# EUROPEAN PATENT APPLICATION

(11) **EP 4 842 164 A1**
(43) Date of publication of application: **18.11.2026**
(21) Application number: 26178894.7
(22) Date of filing: 15.05.2026
(51) Int. Cl.: H10F 10/16, H10F 10/161, H10F 77/12

(54) **SOLAR CELL, MULTI-JUNCTION SOLAR CELL, SOLAR CELL MODULE, AND PHOTOVOLTAIC POWER GENERATION SYSTEM**

(30) Priority: 15.05.2025 JP 2025082185; 27.04.2026 JP 2026073593
(71) Applicant: KABUSHIKI KAISHA TOSHIBA, Kawasaki-shi, Kanagawa 212-0013 (JP)
(72) Inventor: YAMAMOTO, Kazushige, Kawasaki-shi, Kanagawa (JP); NISHIDA, Yasutaka, Kawasaki-shi, Kanagawa (JP); SUGIMOTO, Kanta, Kawasaki-shi, Kanagawa (JP); HONISHI, Yuya, Kawasaki-shi, Kanagawa (JP); TOYOTA, Motohiro, Kawasaki-shi, Kanagawa (JP); MIZUNO, Yukitami, Kawasaki-shi, Kanagawa (JP); NAKAGAWA, Naoyuki, Kawasaki-shi, Kanagawa (JP); SHIBASAKI, Soichiro, Kawasaki-shi, Kanagawa (JP); YAMAMOTO, Takashi, Kawasaki-shi, Kanagawa (JP); WADA, Atsushi, Kawasaki-shi, Kanagawa (JP); YOSHIO, Sara, Kawasaki-shi, Kanagawa (JP); SANO, Junji, Kawasaki-shi, Kanagawa (JP)
(74) Representative: Hoffmann Eitle

(57) **Abstract**

The solar cell according to an embodiment comprises a first electrode, a p-type light-absorbing layer on the first electrode, an n-type layer on the p-type light-absorbing layer, and a second electrode on the n-type layer. A region from the n-type layer side surface of the p-type light-absorbing layer to the first electrode side with a depth of 100 nm is defined as a first region. A region from the center of the thickness direction of the p-type light-absorbing layer to the first electrode side with a depth of 100 nm is defined as a second region. When the photoluminescence spectrum of the p-type light-absorbing layer is measured at a temperature of 100 K or less, the maximum value of the emission intensity in the wavelength range of 900 nm or more and 950 nm or less for the first region is 0 times or more and 2 times or less than the maximum value of the emission intensity in the same wavelength range for the second region.

## Description

### FIELD

Embodiments described herein relate generally to a solar cell, a multi-junction solar cell, a solar cell module, and a photovoltaic power generation system.

### BACKGROUND

One type of new solar cell uses cuprous oxide (Cu₂O) as the light-absorbing layer. Cu₂O is a wide-bandgap semiconductor. Because Cu₂O is a safe and inexpensive material composed of copper and oxygen, which are abundantly available on Earth, it is expected that high-efficiency and low-cost solar cells can be realized.

### BRIEF DESCRIPTION OF THE DRAWINGS

FIG. 1 is a schematic cross-sectional diagram of a solar cell according to an embodiment;
FIG. 2 is a diagram explaining the analysis spots of the solar cell according to an embodiment;
FIG. 3 is a schematic cross-sectional diagram of a solar cell according to an embodiment;

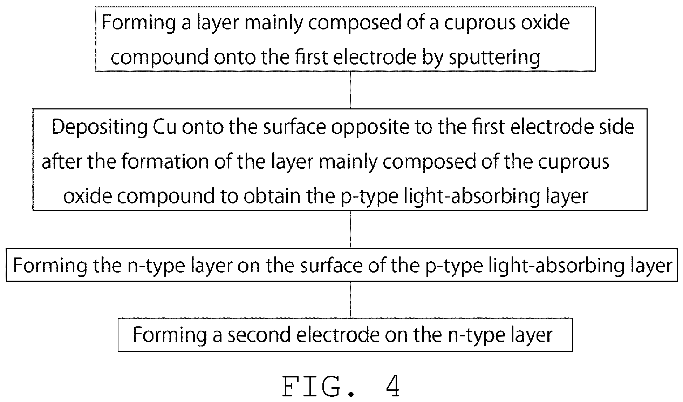

FIG. 4 is a flow-chart for a manufacturing method of a solar cell according to an embodiment;
FIG. 5 is a schematic cross-sectional diagram of a solar cell according to an embodiment;
FIG. 6 is a schematic cross-sectional diagram of a multi-junction solar cell according to an embodiment;
FIG. 7 is a perspective schematic diagram of a solar cell module according to an embodiment;
FIG. 8 is a perspective schematic diagram of a solar cell module according to an embodiment;
FIG. 9 is a configuration diagram of a photovoltaic power generation system according to an embodiment;
FIG. 10 is a schematic diagram of a vehicle according to an embodiment;
FIG. 11 is a schematic diagram of a drone according to an embodiment;
FIG. 12 is a schematic diagram of an electrolytic apparatus according to an embodiment;
FIG. 13 is a table of Examples;
FIG. 14 shows photoluminescence spectra of Examples;
FIG. 15 shows photoluminescence spectra of Examples;
FIG. 16 is a table of Examples;
FIG. 17 is a table of Examples;
FIG. 18 is a cross-sectional SEM image of a p-type light-absorbing layer;
FIG. 19 is a table of Examples;
FIG. 20 is a table of Examples;
FIG. 21 is a table of Examples;
FIG. 22 is a table of Examples;
FIG. 23 is a table of Examples;
FIG. 24 is a table of Examples; and
FIG. 25 is a table of Examples;

### DETAILED DESCRIPTION

The solar cell according to an embodiment comprises a first electrode, a p-type light-absorbing layer on the first electrode, an n-type layer on the p-type light-absorbing layer, and a second electrode on the n-type layer. A region from the n-type layer side surface of the p-type light-absorbing layer to the first electrode side with a depth of 100 nm is defined as the first region. A region from the center of the thickness direction of the p-type light-absorbing layer to the first electrode side with a depth of 100 nm is defined as the second region. When the photoluminescence spectrum of the p-type light-absorbing layer is measured at a temperature of 100 K or less, the maximum value of the emission intensity in the wavelength range of 900 nm or more and 950 nm or less for the first region is 0 times or more and 2 times or less than the maximum value of the emission intensity in the same wavelength range for the second region.

With reference to the drawings, a preferred embodiment of the present invention will be described in detail. Unless otherwise specifically indicated, the physical property values shown are those measured at 25 °C and 1 atm (atmospheric pressure). "Average" denotes an arithmetic mean. Each concentration is the average concentration in the region or layer concerned. In any layer, "a specific element is included (included)" means that the element has been confirmed to exist, for example, by secondary ion mass spectrometry (SIMS); "a specific element is not included" means that the element could not be confirmed, for example, by SIMS.

In the specification, "/" denotes the division sign. However, in the expression "or/and" the "/" means "or". In the specification, "." and "*" denote multiplication. In the specification, "." denotes a decimal point.

The thickness and structure of members described in the specification can be known, for example, from one or more of images obtained by SEM (Scanning Electron Microscope), TEM (Transmission Electron Microscope), HAADF-STEM (High-Angle Annular Dark Field Scanning Transmission Electron Microscopy), and the like. The boundaries of the members described in the specification can be determined from one or more images obtained by scanning electron microscopy or transmission electron microscopy, SEM-EDS (Scanning Electron Microscopy with Energy Dispersive X-ray Spectroscopy) or TEM-EDX (Transmission Electron Microscopy with Energy Dispersive X-ray Spectroscopy), SIMS (Secondary Ion Mass Spectrometry), and the like. The composition of the members described in the specification can be determined by one SIMS, ICP-MS (Inductively Coupled Plasma Mass Spectrometry), SEM-EDX, TEM-EDX, or the like. The crystallinity of the members described in the specification can be evaluated, for example, from XRD (X-ray Diffraction), EBSD (Electron Backscatter Diffraction), images obtained by HAADF-STEM, SEM, TEM or the like. Materials included in the members described in the specification (crystal defects, bonding states, etc.) can be evaluated from HAADF-STEM, PL (Photoluminescence), XPS (X-ray Photoelectron Spectroscopy), or the like. These analysis methods are examples and do not negate the specific analytical methods described in the specification.

### (FIRST EMBODIMENT)

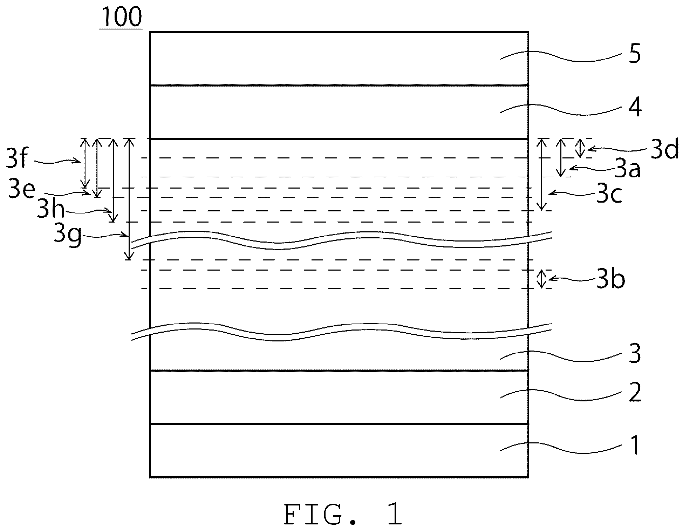

The first embodiment relates to a solar cell. FIG. 1 is a cross-sectional diagram of a solar cell 100 according to the first embodiment. The solar cell 100 shown in FIG. 1 includes a substrate 1, a first electrode 2, a p-type light-absorbing layer 3, an n-type layer 4, and a second electrode 5. It is preferable that an antireflection layer is provided on the light incidence side, for example, the second electrode 5 of the solar cell 100.

When transparent electrodes are used for the first electrode 2 and the second electrode 5, the solar cell 100 according to the embodiment is a transparent solar cell having high transmittance of light in a wavelength band of 700 nm or more and 1200 nm or less.

When the solar cell 100 according to the embodiment is a transparent solar cell using transparent electrodes for the first electrode 2 and the second electrode 5, the solar cell 100 is preferably used on the top cell side (light incidence side).

The substrate 1 is a transparent substrate. Organic substrates such as acrylic resin, polyimide, polycarbonate, polyethylene terephthalate (PET), polypropylene (PP), fluorine-based resins (polytetrafluoroethylene (PTFE), perfluoroethylene propylene copolymer (FEP), ethylene tetrafluoroethylene copolymer (ETFE), polychlorotrifluoroethylene (PCTFE), perfluoroalkoxy alkane (PFA), etc.), polyarylate, polysulfone, polyethersulfone, polyetherimide and the like; or inorganic substrates such as soda lime glass, ultra clear glass, chemically strengthened glass, quartz and the like can be used as the substrate 1. The substrate 1 may be laminated or layered with any of the aforementioned substrates.

Soda lime glass, ultra clear glass, chemically strengthened glass or quartz is preferable for the substrate 1, and soda lime glass, ultra clear glass or quartz is more preferable. The substrate 1 can be omitted.

The first electrode 2 is provided on the substrate 1, and the first electrode 2 is a planar conductive film, preferably. The first electrode 2 is a metal layer, an oxide semiconductor layer, or a conductive layer having light transmittance. The first electrode 2 preferably includes one or more layers of transparent conductive oxide films. Examples of the transparent conductive oxide films include indium tin oxide (ITO), aluminum-doped zinc oxide (AZO), boron-doped zinc oxide (BZO), gallium-doped zinc oxide (GZO), doped tin oxide, titanium-doped indium oxide (ITiO), indium zinc oxide (IZO) and indium gallium zinc oxide (IGZO), hydrogen-doped indium oxide (IOH), etc. The transparent conductive oxide film may be a multilayer film. Examples of dopants for the oxide films such as tin oxide include, but are not limited to, one or more selected from the group consisting of In, Si, Ge, Ti, Cu, Sb, Nb, Ta, W, Mo, F, and Cl. The first electrode 2 preferably includes a doped tin oxide film including one or more elements selected from the group consisting of In, Si, Ge, Ti, Cu, Sb, Nb, Ta, W, Mo, F, and Cl. In the doped tin oxide film, it is preferable that the one or more elements selected from the group consisting of In, Si, Ge, Ti, Cu, Sb, Nb, Ta, W, Mo, F, and Cl are included in an amount of 10 atomic percent or less with respect to tin included in the tin oxide film. As the first electrode 2, a multilayer film comprising a transparent conductive oxide film and a metal film can be used. Examples of metals (including alloys) included in the metal film include but are not limited to Mo, Au, Cu, Ag, Al, Ta, and W. It is preferable that the first electrode 2 includes a dot-shaped, line-shaped, or mesh-shaped electrode (one or more selected from the group consisting of metal, alloy, graphene, conductive nitride, and conductive oxide) between the transparent conductive oxide film and the substrate 1. The opening ratio for the metal in the dot-shaped, line-shaped, or mesh-shaped electrode is preferably 50% or more with respect to the transparent conductive oxide film. Examples of metals for the dot-shaped, line-shaped, or mesh-shaped electrodes include but are not limited to Mo, Au, Cu, Ag, Al, Ta, and W. When a metal film is used for the first electrode 2, it is preferable that the film thickness is 5 nm or less from the viewpoint of transmittance. When using line-shaped or mesh-shaped metal films, the transmittance is secured by the openings; therefore, this limitation does not apply to the film thickness of the metal films.

Examples of the first electrode 2 include a transparent electrode comprising an ITO film and a multilayer film comprising an ITO film and a doped tin oxide film where the doped tin oxide film is positioned on the p-type light-absorbing layer 3 side, etc.

The thickness of the first electrode 2 is preferably 50 nm or more and 500 nm or less; more preferably 50 nm or more and 300 nm or less; and even more preferably 75 nm or more and 200 nm or less.

The solar cell 100 may include an intermediate layer including a low refractive index insulating layer such as SiO₂ or MgF₂ between the substrate 1 and the first electrode 2.

The solar cell 100 may include an intermediate layer between the p-type light-absorbing layer 3 and the n-type layer 4.

The p-type light-absorbing layer 3 is overall a p-type semiconductor layer. The p-type light-absorbing layer 3 is provided on the first electrode 2. It is preferable that the p-type light-absorbing layer 3 is in direct contact with the first electrode 2. The p-type light-absorbing layer 3 is positioned between the first electrode 2 and the n-type layer 4. It is preferable that the p-type light-absorbing layer 3 is in direct contact with the n-type layer 4. The p-type light-absorbing layer 3, which is in direct contact with the n-type layer 4, preferably forms a pn-junction with the n-type layer 4. The p-type light-absorbing layer 3 is preferably a compound semiconductor layer. A semiconductor layer including a compound having a cuprite structure such as cuprous oxide is preferable for the p-type light-absorbing layer 3. The p-type light-absorbing layer 3 preferably comprises a cuprous oxide compound as its main component. The cuprous oxide compound preferably has a cuprite structure. Hereinafter, a solar cell using a cuprous oxide compound in the p-type light-absorbing layer 3 will be described by example. For other compounds used in the p-type light-absorbing layer 3, it is preferable to adopt a configuration suitable for the respective compound and the first embodiment of the solar cell 100.

It is preferable that the p-type light-absorbing layer 3 is a semiconductor layer including cuprous oxide compound. It is preferable that the p-type light-absorbing layer 3 is polycrystalline of the cuprous oxide compound. A trace amount of impurities such as copper (Cu), cupric oxide (CuO), and copper hydroxide (Cu(OH)₂) may be included in the p-type light-absorbing layer 3.

When all elements except oxygen element included in the p-type light-absorbing layer 3 are set to 100%, it is preferable that the copper element included in the p-type light-absorbing layer 3 is 90% or more and 100% or less; more preferably 95% or more and 100% or less; even more preferably 98% or more and 100% or less; and further even more preferably 99% or more and 100% or less.

When all elements except oxygen element included in the p-type light-absorbing layer 3 are set to 100%, it is preferable that the copper element included in the p-type light-absorbing layer 3 is 90% or more and 99.9% or less; more preferably 95.0% or more and 99.9% or less; even more preferably 98% or more and 99.9% or less; and further even more preferably 99.0% or more and 99.9% or less.

The cuprous oxide compound includes copper and oxygen, and further optionally an element represented by M1. The element represented by M1 is preferably one or more elements selected from the group consisting of Cl, F, Br, I, Sn, Sb, Ag, Li, Na, K, Cs, Rb, Al, In, Zn, Mg, Ga, Si, Ge, N, P, B, Ti, Hf, Zr, Be, Ca, Sr and Ba.

The amount of oxygen atoms included in the cuprous oxide compound is preferably 0.48 or more and 0.56 or less when the number of copper atoms is set to 1. If there is more oxygen compared to copper, the ratio of copper oxide included in the cuprous oxide compound increases, which narrows the band gap and reduces the transmittance of the p-type light-absorbing layer 3. If there is less oxygen compared to copper, the amount of copper included in the cuprous oxide compound increases, which reduces the transmittance. Furthermore, if the ratio of oxygen to copper does not fall within the above range, it becomes difficult for the cuprous oxide compound to have a cuprous structure.

It is preferable that 95 wt% or more and 100 wt% or less of the p-type light-absorbing layer 3 is composed of the cuprous oxide compound. It is even more preferable that 98 wt% or more and 100 wt% or less of the p-type light-absorbing layer 3 is composed of the cuprous oxide compound, and further even more preferable that 99 wt% or more and 100 wt% or less of the p-type light-absorbing layer 3 is composed of the cuprous oxide compound. The p-type light-absorbing layer 3 can be entirely composed of a cuprous oxide compound.

It is preferable that the p-type light-absorbing layer 3 has a low degree of heterogenous and has good crystallinity because this increases the transmittance of the p-type light-absorbing layer 3. The band gap of the p-type light-absorbing layer 3 can be adjusted by incorporating elements other than Cu and O, for example. It is preferable that the band gap of the p-type light-absorbing layer 3 is 2.0 eV or more and 2.2 eV or less. Within this range of band gaps, solar light can be efficiently utilized in both the top cell and bottom cell when a multi-junction solar cell utilizes a silicon-based absorbing layer as the bottom cell and the embodiment's solar cell as the top cell. It is preferable that the p-type light-absorbing layer 3 includes Sn or/and Sb. The Sn or Sb in the p-type light-absorbing layer 3 may be added to the p-type light-absorbing layer 3, or it may originate from the first electrode 2. The Ga included in the p-type light-absorbing layer 3 is not included in the raw material for forming the p-type light-absorbing layer 3 but is diffused from the n-type layer 4 including Ga. When other elements are used during the formation of the n-type layer 4, these elements may also diffuse into the p-type light-absorbing layer 3. Diffusion of elements from an intermediate layer not shown in the drawings into the p-type light-absorbing layer 3 is also possible.

The compositional ratio mentioned above for the p-type light-absorbing layer 3 is the overall compositional ratio of the p-type light-absorbing layer 3. It is preferable that the compound compositional ratio described above for the p-type light-absorbing layer 3 be met throughout the p-type light-absorbing layer 3.

It is preferable that the p-type light-absorbing layer 3 has a p⁺ type (p plus type) region on the first electrode 2 side.

It is preferable that the p-type light-absorbing layer 3 has a p⁻ type (p minus type) region on the n-type layer 4 side.

It is preferable that the p-type light-absorbing layer 3 has a p⁻ type (p minus type) region on the n-type layer 4 side and a p⁺ type (p plus type) region on the first electrode 2 side.

It is preferable that the thickness of the p-type light-absorbing layer 3 is 2 µm or more and 10 µm or less; more preferably 2.5 µm or more and 7.0 µm or less. It is preferable that the p-type light-absorbing layer 3 be the thickest layer among the layers included between the first electrode 2 and the second electrode 5. It is preferable that the p-type light-absorbing layer 3 be the thickest semiconductor layer included in the solar cell 100.

The thickness of the p-type light-absorbing layer 3 is not limited to the thicknesses described above when Cu₂O is epitaxially grown or when a copper plate is oxidized. When Cu₂O is epitaxially grown, the thickness of the p-type light-absorbing layer 3 is preferably 0.2 µm or more and 3 µm or less. When a copper plate is oxidized, the thickness of the p-type light-absorbing layer 3 is preferably 100 µm or more and 1 mm or less.

It is preferable that the surface of the p-type light-absorbing layer 3 on the n-type layer 4 side has fine unevenness. The average deviation of the surface roughness of the p-type light-absorbing layer 3 on the n-type layer 4 side is preferably 50 nm or more; more preferably 50 nm or more and 500 nm or less; and further more preferably 55 nm or more and 300 nm or less.

It is preferable that the p-type light-absorbing layer 3 be formed by a sputtering method, for example. Specifically, a member on which the first electrode 2 is formed on the substrate 1 is heated to 300°C or more and 1000°C or less, and the oxygen partial pressure is within the range of 0.01 Pa or more and 4.8 Pa or less, and sputtering is performed at a rate within the range of 0.02 µm/min or more and 20 µm/min or less. From the viewpoint of forming a transparent, large-grained polycrystalline film, it is preferable that the oxygen partial pressure satisfies the following relationship when the deposition rate is d µm/min (However, when calculating the oxygen partial pressure, the unit of deposition rate is ignored.) : 0.20 × d Pa or more and 1.00 × d Pa or less (for example, in the case of high-temperature sputtering, 0.20 × d Pa or more and 0.50 × d Pa or less is preferable; in the case of low-temperature sputtering, 0.55 × d Pa or more and 1.00 × d Pa or less is preferable). It is also preferable that the heating temperature be higher than 550°C and 850°C or less. Elements represented by M1 can be added during film formation.

By forming the p-type light-absorbing layer 3 by the method described above, large-grained cuprous oxide compound is formed. It is preferable that the p-type light-absorbing layer 3 be a polycrystalline material including crystals of a cuprous oxide compound with a grain size 5 times or more the thickness of the p-type light-absorbing layer 3.

The p-type light-absorbing layer 3 may also be a Cu₂O layer formed by epitaxial growth. When the p-type light-absorbing layer 3 is formed by epitaxial growth, Cu₂O can be grown using the first electrode 2 or an intermediate layer provided on the first electrode 2 as a substrate.

The p-type light-absorbing layer 3 may also be a Cu₂O layer obtained by oxidizing a Cu plate.

When there is a Cu vacancy in the p-type light-absorbing layer 3, the carrier concentration increases. However, at the pn-junction, an increase in carrier concentration results in the n-type layer 4 side of the p-type light-absorbing layer 3 becoming p⁺ type, which is undesirable. A high carrier concentration on the n-type layer 4 side of the p-type light-absorbing layer 3 can lead to increasing discontinuity in the conduction band and increasing recombination due to the n-type layer 4 side acting as a carrier mobility barrier. Therefore, a locally high carrier concentration on the n-type layer 4 side of the p-type light-absorbing layer 3 leads to a decrease in FF (fill factor) and conversion efficiency (Eff.). Repairing Cu vacancies improves the characteristics of the solar cell 100.

When forming a cuprous oxide compound, Cu vacancies tend to exist relatively more on the crystal surface and grain boundaries when the p-type light-absorbing layer 3 is polycrystalline. For example, when Cu₂O is formed by oxidation of Cu, Cu vacancies are likely to migrate to the surface rather than remaining at the center of the crystal.

In the present invention, photoluminescence analysis can be used to evaluate Cu vacancies on the surface of the p-type light-absorbing layer 3. This allows us to obtain a stacked body (a stacked body of the substrate 1, the first electrode 2 and the p-type light-absorbing layer 3) or a solar cell 100 having a p-type light-absorbing layer 3 with effectively reduced Cu vacancies on the n-type layer 4 side.

When measuring a photoluminescence spectrum at a temperature of 100 K (Kelvin) or less for the p-type light-absorbing layer 3 (hereinafter, the emission intensity refers to the emission intensity measured by photoluminescence at a temperature of 100 K or less), the emission intensity in the wavelength range from 900 nm to 950 nm (first wavelength range) becomes high when the surface on the side opposite to the first electrode 2 side (n-type layer 4 side) is measured, when Cu vacancies are not reduced. The emission intensity of the first wavelength range on the first electrode 2 side and in the bulk is low, so the emission intensity in the first wavelength range is relatively high on the side opposite to the first electrode 2 side.

When the emission intensity in the first wavelength region is low in a region from the n-type layer 4 side surface of the p-type light-absorbing layer 3 to the first electrode 2 side with a depth of 100 nm (first region 3a), FF (FF = (Vmpp × Jmpp) / (Voc × Jsc)) of the solar cell 100 is improved and contributes to improving conversion efficiency.

The emission in the first wavelength range is caused by Cu vacancies, while the emission intensity in the wavelength range from 600 nm to 650 nm (second wavelength range) is considered to be due to Cu₂O without defects. The bandgap energy corresponding to the second wavelength range is about 2.0 eV, and the bandgap energy corresponding to the first wavelength range is about 1.3 eV.

Even when all Cu vacancies are not repaired in the p-type light-absorbing layer 3 of the solar cell according to this embodiment, when photoluminescence analysis is performed, emission in the first wavelength range is confirmed on the surface of the p-type light-absorbing layer 3 although emission in the first wavelength range is absent inside the p-type light-absorbing layer 3 and emission occurs substantially only in the second wavelength range inside the p-type light-absorbing layer 3. Cu vacancies on the surface of the p-type light-absorbing layer 3 (the surface of the p-type light-absorbing layer 3 opposite to the first electrode 2 side) present in Cu₂O p-type light-absorbing layers with a high CuO phase and poor film quality, as well as those considered to be single-phase Cu₂O. Repairing Cu vacancies in Cu₂O p-type light-absorbing layers with a high CuO phase and poor film quality allows for the overall repair of Cu vacancies in the p-type light-absorbing layer 3. However, repairing Cu vacancies not only on the surface but throughout the entire p-type light-absorbing layer 3 can result in an undesirable decrease in the overall carrier concentration of the p-type light-absorbing layer 3. From this perspective, it is preferable to perform the repair on a member where Cu vacancies are locally present on the surface of the p-type light-absorbing layer 3 before the Cu vacancies are repaired.

When Cu vacancies on the surface of the p-type light-absorbing layer 3 are repaired, emission in the first wavelength range on the surface of the p-type light-absorbing layer 3 decreases, becoming similar degree to the emission in the first wavelength range of the bulk p-type light-absorbing layer 3. Let a second region 3b be a region from the center of the thickness direction of the p-type light-absorbing layer to the first electrode side (the thickness direction is the direction from the surface on the first electrode 2 side to the opposite side) with a depth of 100 nm. Treating the second region 3b as bulk of the p-type light-absorbing layer 3, it is preferable that the maximum value of the emission intensity in the first wavelength range in the first region 3a is 0 times or more (or greater than 0 times) and 2 times or less the maximum value of the emission intensity in the first wavelength range in the second region 3b; more preferably 0 times or more (or greater than 0 times) and 1 time or less; and further more preferably 0 times or more (or greater than 0 times) and 0.5 times or less.

From the viewpoint of improving FF, it is preferable that "([maximum value of emission intensity in the first wavelength range in the first region 3a] × [maximum value of emission intensity in the second wavelength range in the second region 3b]) / ([maximum value of emission intensity in the second wavelength range in the first region 3a] × [maximum value of emission intensity in the first wavelength range in the second region 3b])" is 0 or more (or greater than 0) and 20 or less; more preferably 0 or more (or greater than 0) and 3.3 or less; and further more preferably 0 or more

(or greater than 0) and 0.5 or less. If Cu vacancies are not repaired, "([maximum value of emission intensity in the first wavelength range in the first region 3a] × [maximum value of emission intensity in the second wavelength range in the second region 3b]) / ([maximum value of emission intensity in the second wavelength range in the first region 3a] × [maximum value of emission intensity in the first wavelength range in the second region 3b])" will take on a larger value than the ranges mentioned above.

The elements that repair Cu vacancies are preferably one or more first elements selected from the group consisting of Zn, Mg, Li, Na, K, Rb, Cs, Be, Ca, Sr, and Ba, or Cu itself. It is preferable for these elements to be locally present on the surface opposite the first electrode 2 side of the p-type light-absorbing layer 3. The carrier concentration tends to decrease in regions including elements that repair Cu vacancies. While a decrease in carrier concentration on the side opposite the first electrode 2 side of the p-type light-absorbing layer 3 is preferable, it is undesirable for the overall carrier concentration of the p-type light-absorbing layer 3 to decrease. Even when elements are present in bulk p-type light-absorbing layer 3, they can repair Cu vacancies but may also lead to a decrease in carrier concentration.

When the p-type light-absorbing layer 3 is polycrystalline of cuprous oxide compound, it is preferable that elements repairing Cu vacancies are present at grain boundaries included in the first region 3a. When the p-type light-absorbing layer 3 is polycrystalline of cuprous oxide compound, it is preferable for the first elements to be present at grain boundaries included in the first region 3a.

Cu is preferable as the element that repairs Cu vacancies. Even when Cu is used as the element that repairs Cu vacancies, the number of oxygen atoms included in the cuprous oxide compound is preferably 0.48 or more and 0.56 or less, with respect to the copper atom count set to 1, both in the whole p-type light-absorbing layer 3 and in the first region 3a.

Zn is preferable as the element that repairs Cu vacancies; and Zn and Cu are also preferable.

Mg is preferable as the element that repairs Cu vacancies; Mg and Cu are preferable; and Zn, Mg and Cu are also preferable.

Ca is preferable as the element that repairs Cu vacancies; Ca and Cu are preferable; and Zn, Ca, and Cu are also preferable.

One or more elements selected from the group consisting of Zn, Mg, Li, Na, and Ca are preferable as the first element that repairs Cu vacancies; Zn, Mg, and Ca are even more preferable.

Considering the continuity of the conduction band, when a region extending from the surface of the p-type light-absorbing layer 3 on the side opposite the first electrode 2 to the first electrode 2 with a depth of 1 µm is defined as a third region 3c, it is preferable that the concentration of the first element included in the third region 3c be 90 atom% or more and 100 atom% or less of the concentration of the first element included in the p-type light-absorbing layer 3.

Considering the continuity of the conduction band, when a region extending from the surface of the p-type light-absorbing layer 3 on the side opposite the first electrode 2 to the first electrode 2 with a depth of 50 nm is defined as a fourth region 3d, it is preferable that the concentration of the first element included in the fourth region 3d be 30 atom% or more and 80 atom% or less of the concentration of the first element included in the p-type light-absorbing layer 3. Rather than the first element being concentrated almost exclusively in the fourth region 3d, it is also present in the region toward the first electrode side. It is preferable for the first element to be present over a wider range than the fourth region 3d in order to reliably repair surface Cu vacancies.

Considering the continuity of the conduction band, when a region extending from the surface of the p-type light-absorbing layer on the side opposite the first electrode 2 to the first electrode 2 with a depth of 0.7 µm is defined as a fifth region 3e, it is preferable that the concentration of the first element included in the fifth region 3e be 90 atom% or more and 100 atom% or less of the concentration of the first element included in the p-type light-absorbing layer 3.

Considering the continuity of the conduction band, when a region extending from the surface of the p-type light-absorbing layer 3 on the side opposite the first electrode 2 to the first electrode 2 with a depth of 0.6 µm is defined as a sixth region 3f, it is preferable that the concentration of the first element included in the sixth region 3f be 90 atom% or more and 100 atom% or less of the concentration of the first element included in the p-type light-absorbing layer 3.

Considering the continuity of the conduction band, when a region extending from the surface on the side opposite the first electrode 2 to the first electrode 2 with 30% of the thickness H of the p-type light-absorbing layer 3 is defined as the seventh region 3g, it is preferable that the concentration of the first element included in the seventh region 3g be 90 atom% or more and 100 atom% or less of the concentration of the first element included in the p-type light-absorbing layer 3.

Considering the continuity of the conduction band, when a region extending from the surface on the side opposite the first electrode 2 to the first electrode 2 with 20% of the thickness H of the p-type light-absorbing layer 3 is defined as the eighth region 3h, it is preferable that the concentration of the first element included in the eighth region 3h be 90 atom% or more and 100 atom% or less of the concentration of the first element included in the p-type light-absorbing layer 3.

The surface resistivity Ω/cm² at the cross section of the first region 3a in the thickness direction of the p-type light-absorbing layer 3 is preferably 0.3 times or more and 10000 times or less than the surface resistivity [Ω/cm²] at the cross section of the second region 3b; more preferably, 1 time or more and 10000 times or less; and even more preferably, 10 times or more and 10000 times or less. Regions with Cu vacancies tend to have low resistance. The presence of Cu vacancy regions can cause carrier recombination, leading to a decrease in current density. In this embodiment, the solar cell 100 has a reduced Cu vacancy on the side opposite the first electrode 2 of the p-type light-absorbing layer 3, resulting in an overall higher resistance. Surface resistivity can be determined by scanning spreading resistance microscopy (SSRM).

The carrier concentration in the first region 3a is preferably 1 × 10¹¹ cm⁻³ or more and 1 × 10¹⁵ cm⁻³ or less; more preferably, 1 × 10¹¹ cm⁻³ or more and 3 × 10¹⁴ cm⁻³ or less; and even more preferably, 1 × 10¹¹ cm⁻³ or more and 1 × 10¹⁴ cm⁻³ or less. When Cu vacancies are not repaired, the carrier concentration in the first region 3a tends to be 3 × 10¹⁵ cm⁻³ or more. The carrier concentration can be determined by device simulation (e.g., e-ARC method) based on current-voltage characteristics.

The carrier concentration in the second region 3b is preferably 1 × 10¹² cm⁻³ or more and 1 × 10¹⁵ cm⁻³ or less; more preferably, 1 × 10¹³ cm⁻³ or more and 7.5 × 10¹⁴ cm⁻³ or less; and even more preferably, 1 × 10¹⁴ cm⁻³ or more and 5 × 10¹⁴ cm⁻³ or less. Even when Cu vacancies are not repaired, the carrier concentration in the second region 3b tends to be within this range. When a large number of elements that repair Cu vacancies are included in the bulk (second region 3b), the carrier concentration of the entire p-type light-absorbing layer 3 will decrease. Therefore, it is preferable for the carrier concentration in the bulk (second region 3b) to be within the above range.

The carrier concentration in the first region 3a is preferably 0.0001 times or more and 3 times or less than the carrier concentration in the second region 3b; more preferably, 0.0001 times or more and 1 time or less; and even more preferably, 0.0001 times or more and 0.3 times or less. When Cu vacancies are not repaired, the carrier concentration in the first region 3a tends to be 3 times or more than the carrier concentration in the second region 3b.

To repair Cu vacancies, the element that repairs Cu vacancies can be simply deposited onto the surface of the p-type light-absorbing layer 3 after the formation of the p-type light-absorbing layer 3. When the first element is added during the formation of the p-type light-absorbing layer 3, it will diffuse throughout the entire p-type light-absorbing layer 3 and Cu vacancies will still form as described above. Therefore, even when the first element and/or the element represented by M1 is added during the formation of the p-type light-absorbing layer 3, the solar cell 100 can be obtained by depositing an element that repairs Cu vacancies onto the surface of the p-type light-absorbing layer 3 after its formation.

Here are more specific examples of Cu vacancy repair: After forming a layer mainly composed of cuprous oxide compound (50 wt% or more; preferably 90 wt% or more, more preferably 95 wt% or more; and even more preferably 98 wt% or more) by sputtering, for example, the element that repairs Cu vacancies is deposited onto the surface of the layer mainly composed of cuprous oxide and allowed to diffuse. Preferably, the deposition is performed directly onto the surface of the layer mainly composed of cuprous oxide compound. The element that repairs Cu vacancies is diffused into the layer mainly composed of cuprous oxide by heating at a temperature below the sputtering temperature mentioned above, which is higher than room temperature (25 °C). The diffusion temperature for the element that repairs Cu vacancies after depositing the element that repairs Cu vacancies whose amount is preferably slightly excess for the Cu vacancies, is a temperature at which the PL emission in the first wavelength region of the first region 3a that observed on the surface of the layer mainly composed of cuprous oxide compound becomes lower than that before repairing Cu vacancies; or a temperature at which carrier concentration of bulk of the layer mainly composed of cuprous oxide compound after repairing Cu vacancies is changed from that before repairing Cu vacancies. The optimum processing temperature range can be determined from this phenomenon. Multiple experiments will reveal an appropriate temperature range. By gradually decreasing the deposition amount of the element that repairs Cu vacancies in several experiments and evaluating the carrier concentration in the bulk, a condition where the element that repairs Cu vacancies is not excessively deposited can be found. This condition should ideally be investigated for each type of element that repairs Cu vacancies. As a result, it becomes possible to achieve both the desired Cu vacancy repair and the suppression of carrier concentration reduction in the bulk. Similarly, the optimum processing time can be determined empirically. After repairing Cu vacancies, an oxidizing treatment may be performed on a very thin region (e.g., a region narrower than the first region 3a) of the surface of the p-type light-absorbing layer 3.

The n-type layer 4 is an n-type semiconductor layer that transmits visible light. The n-type layer 4 is arranged between the p-type light-absorbing layer 3 and the second electrode 5. Preferably, the n-type layer 4 is provided on the p-type light-absorbing layer 3. The n-type layer 4 can be formed by, for example, the atomic layer deposition (ALD) method. The n-type layer 4 is preferably mainly amorphous but may contain some crystalline regions.

The n-type layer 4 preferably comprises a compound (oxide) mainly composed of Ga and a compound (oxide) mainly composed of Zn. When the n-type layer 4 comprises multiple n-type layers, the semiconductor layer comprising a compound (oxide) mainly composed of Ga or a compound (oxide) mainly composed of Zn is preferably in direct contact with the p-type light-absorbing layer 3.

The thickness of the n-type layer 4 is typically 3 nm or more and 100 nm or less. When the thickness of the n-type layer 4 is less than 3 nm, leakage current may occur due to poor coverage of the n-type layer 4, which may deteriorate the characteristics. Coverage is good for any film thickness. If the thickness of the n-type layer 4 exceeds 50 nm, excessive high resistance of the n-type layer 4 may lead to a decrease in performance and a decrease in short-circuit current due to reduced transmittance. Therefore, the thickness of the n-type layer 4 is more preferably 3 nm or more and 20 nm or less; and even more preferably 5 nm or more and 20 nm or less.

The compound mainly composed of Ga preferably include Ga₂O₃ or an oxide including an element represented by M2 and Ga. The oxide (compound) mainly composed of Ga is preferably an oxide having an average composition expressed as Gaₕ₁M2ᵢ₁Oⱼ₁. The variables h1, i1 and j1 preferably satisfy 1.8 ≤ h1 ≤ 2.1, 0.0 ≤ i1 ≤ 0.2 and 2.9 ≤ j1 ≤ 3.1. The oxide includes the element represented by M2 and Ga. M2 is preferably selected from the group consisting of one or more elements selected from H, Sn, Sb, Cu, Ag, Li, Na, K, Cs, Rb, Al, In, Zn, Mg, Si, Ge, N, B, Ti, Hf, Zr, Ca, Ce, La, Pr and Nd. The first layer which is one of multiple layers of the n-type layer 5 and located on the p-type light-absorbing layer 3 side, preferably includes the oxide having an average composition expressed as Gaₕ₁M2ᵢ₁Oⱼ₁ in an amount of 90 wt% or more and 100 wt% or less.

The second electrode 5 is disposed on the n-type layer 4. When the side of the second electrode 5 is the light incident side, the second electrode 5 is a transparent electrode with respect to visible light. A transparent conductive oxide film is preferably used for the second electrode 5. The transparent conductive oxide film used in the second electrode 5 is preferably one or more semiconductor conductive films selected from the group consisting of indium tin oxide, doped tin oxide aluminum-doped zinc oxide, boron-doped zinc oxide, gallium-doped zinc oxide, indium-doped zinc oxide, titanium-doped indium oxide, indium gallium zinc oxide and hydrogen-doped indium. For a dopant to the film such as tin oxide, one or more selected from the group consisting of In, Si, Ge, Ti, Cu, Sb, Nb, Ta, W, Mo, F and Cl can be used without particular limitation. The second electrode 5 can include an electrode having a mesh shape or a line shape to reduce the resistance of the oxide transparent conductive film. Materials for the mesh-shaped or line-shaped electrodes are not particularly limited, such as Mo, Au, Cu, Ag, Al, Ta, or W. Graphene can also be used for the second electrode 5. It is preferable that the graphene is laminated with silver nanowires.

The thickness of the second electrode 5 is determined by observation of a cross-section using an electron microscope and a profilometer.

The thickness of the second electrode 5 is 30 nm or more and 2 µm or less; more preferably 30 nm or more and 100 nm or less; and even more preferably 30 nm or more and 70 nm or less.

The second electrode 5 is preferably formed by, for example, ALD or sputtering.

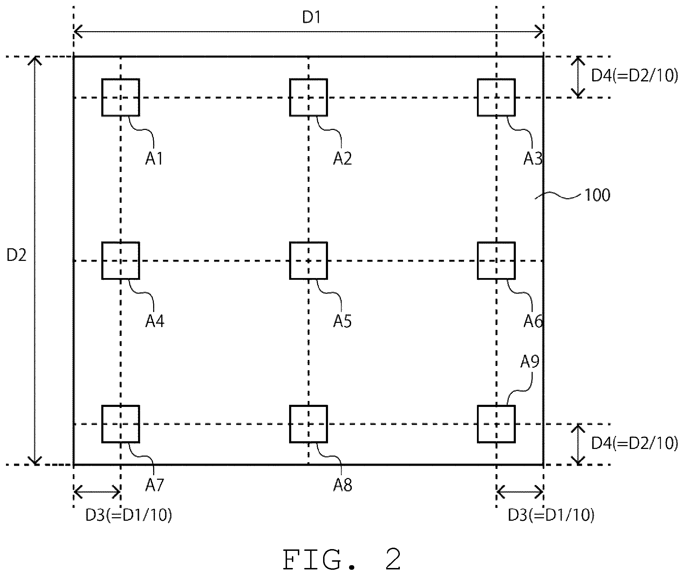

Composition analysis of the p-type light-absorbing layer 3 and other layers can be performed, for example, by analyzing analysis spots (A1 to A9) distributed as evenly spaced as possible across the solar cell using SEM-EDX (Scanning Electron Microscopy-Energy Dispersive X-ray Spectroscopy) or TEM-EDX (Transmission Electron Microscopy-Energy Dispersive X-ray Spectroscopy), as illustrated in FIG. 2, which describes the arrangement of analysis spots. FIG. 2 is a schematic diagram showing the solar cell 100 viewed from the side of the second electrode 5. When analyzing the composition of the solar cell 100, D1 represents the length in the width direction (long side) of the solar cell 100, and D2 represents the length in the depth direction (short side) of the solar cell 100. By magnifying by 2 million times with TEM and analyzing a 100 nm × 100 nm area including the center of each analysis spot, the composition can be determined. Furthermore, the center of each analysis spot can be analyzed with XPS in the thickness direction of the solar cell 100 to evaluate the chemical bonding state and identify the compounds included in each layer. Scanning electron microscopy and the like can be used to observe the solar cell 100 from the side of the second electrode 5, enabling the analysis of surface unevenness and the particle size of each layer.

### (SECOND EMBODIMENT)

The second embodiment relates to a solar cell and a manufacturing method of the solar cell. The solar cell according to the second embodiment is an example of a solar cell having a p-type light-absorbing layer 3 in which Cu vacancies have been repaired, as described in the first embodiment.

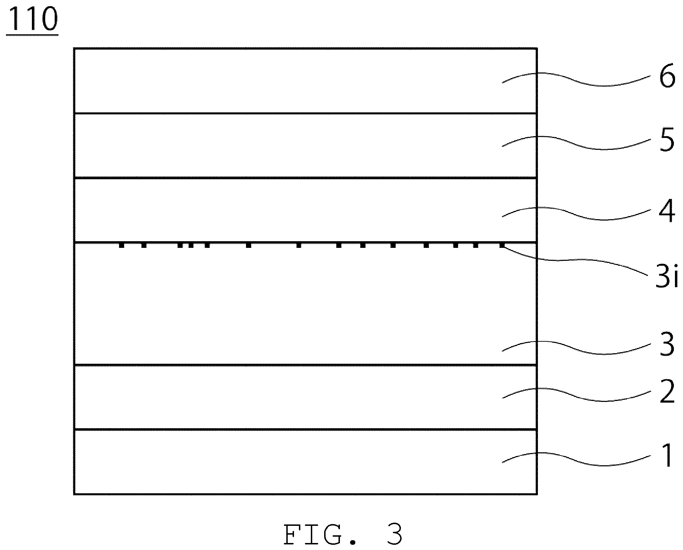

FIG. 3 shows a schematic cross-sectional diagram of a solar cell 110 according to the second embodiment. The solar cell 110 according to the second embodiment comprises a substrate 1, a first electrode 2, a p-type light-absorbing layer 3, an n-type layer 4, and a second electrode 5. It is preferable that an antireflection layer be provided on the light incident side, for example, on the second electrode 5 of the solar cell 110. A recess 3i exists on the surface of the p-type light-absorbing layer 3 on the n-type layer 4 side.

The substrate 1, the first electrode 2, the n-type layer 4, and the second electrode 5 according to the second embodiment are common to those of the first embodiment. In this second embodiment, descriptions of the substrate 1, the first electrode 2, the n-type layer 4, and the second electrode 5 will be omitted.

The p-type light-absorbing layer 3 is overall a p-type semiconductor layer. The p-type light-absorbing layer 3 is provided on the first electrode 2. The p-type light-absorbing layer 3 can be obtained by depositing a thin layer of Cu onto the layer mainly composed of a cuprous oxide compound and then diffusing Cu into the layer mainly composed of a cuprous oxide compound. It is preferable that the p-type light-absorbing layer 3 is in direct contact with the first electrode 2. The p-type light-absorbing layer 3 is positioned between the first electrode 2 and the n-type layer 4. It is preferable that the p-type light-absorbing layer 3 is in direct contact with the n-type layer 4. The p-type light-absorbing layer 3, which is in direct contact with the n-type layer 4, preferably forms a pn-junction with the n-type layer 4. The p-type light-absorbing layer 3 is preferably a compound semiconductor layer. A semiconductor layer including a compound having a cuprite structure such as cuprous oxide is preferable for the p-type light-absorbing layer 3. The p-type light-absorbing layer 3 preferably comprises a cuprous oxide compound as its main component. The cuprous oxide compound preferably has a cuprite structure. Hereinafter, a solar cell using a cuprous oxide compound in the p-type light-absorbing layer 3 will be described by example. For other compounds used in the p-type light-absorbing layer 3, it is preferable to adopt a configuration suitable for the respective compound and the second embodiment of the solar cell 110.

It is preferable that the p-type light-absorbing layer 3 (the layer mainly composed of a cuprous oxide compound) is a semiconductor layer including cuprous oxide compound. It is preferable that the p-type light-absorbing layer 3 (the layer mainly composed of a cuprous oxide compound) is polycrystalline cuprous-oxide. A trace amount of impurities such as copper (Cu), cupric oxide (CuO), and copper hydroxide (Cu(OH)₂) may be included in the p-type light-absorbing layer 3.

When all elements except oxygen element included in the p-type light-absorbing layer 3 (the layer mainly composed of a cuprous oxide compound) are set to 100%, it is preferable that the copper element included in the p-type light-absorbing layer 3 is 90% or more and 100% or less; more preferably 95% or more and 100% or less; even more preferably 98% or more and 100% or less; and further even more preferably 99% or more and 100% or less.

When all elements except oxygen element included in the p-type light-absorbing layer 3 (the layer mainly composed of a cuprous oxide compound) are set to 100%, it is preferable that the copper element included in the p-type light-absorbing layer 3 (the layer mainly composed of a cuprous oxide compound) is 90% or more and 99.9% or less; more preferably 95.0% or more and 99.9% or less; even more preferably 98% or more and 99.9% or less; and further even more preferably 99.0% or more and 99.9% or less.

The cuprous oxide compound includes copper and oxygen, and further optionally an element represented by M1. The element represented by M1 is preferably one or more elements selected from the group consisting of Cl, F, Br, I, Sn, Sb, Ag, Li, Na, K, Cs, Rb, Al, In, Zn, Mg, Ga, Si, Ge, N, P, B, Ti, Hf, Zr, Be, Ca, Sr and Ba.

The amount of oxygen atoms included in the cuprous oxide compound is preferably 0.48 or more and 0.56 or less when the number of copper atoms is set to 1. If there is more oxygen compared to copper, the ratio of copper oxide included in the cuprous oxide compound increases, which narrows the band gap and reduces the transmittance of the p-type light-absorbing layer 3. If there is less oxygen compared to copper, the amount of copper included in the cuprous oxide compound increases, which reduces the transmittance. Furthermore, if the ratio of oxygen to copper does not fall within the above range, it becomes difficult for the cuprous oxide compound to have a cuprous structure.

It is preferable that 95 wt% or more and less than 100 wt% of the p-type light-absorbing layer 3 (the layer mainly composed of a cuprous oxide compound) is composed of the cuprous oxide compound. It is even more preferable that 98 wt% or more and less than 100 wt% of the p-type light-absorbing layer 3 (the layer mainly composed of a cuprous oxide compound) is composed of the cuprous oxide compound, and further even more preferable that 99 wt% or more and less than 100 wt% of the p-type light-absorbing layer 3 (the layer mainly composed of a cuprous oxide compound) is composed of the cuprous oxide compound. The p-type light-absorbing layer 3 can be entirely composed of a cuprous oxide compound.

It is preferable that the p-type light-absorbing layer 3 has a low degree of heterogenous and has good crystallinity because this increases the transmittance of the p-type light-absorbing layer (the layer mainly composed of a cuprous oxide compound) 3. The band gap of the p-type light-absorbing layer (the layer mainly composed of a cuprous oxide compound) 3 can be adjusted by incorporating elements other than Cu and O, for example. It is preferable that the band gap of the p-type light-absorbing layer (the layer mainly composed of a cuprous oxide compound) 3 is 2.0 eV or more and 2.2 eV or less. Within this range of band gaps, solar light can be efficiently utilized in both the top cell and bottom cell when a multi-junction solar cell utilizes a silicon-based absorbing layer as the bottom cell and the embodiment's solar cell as the top cell. It is preferable that the p-type light-absorbing layer (the layer mainly composed of a cuprous oxide compound) 3 includes Sn or/and Sb. The Sn or Sb in the p-type light-absorbing layer (the layer mainly composed of a cuprous oxide compound) 3 may be added to the p-type light-absorbing layer (the layer mainly composed of a cuprous oxide compound) 3, or it may originate from the first electrode 2. The Ga included in the p-type light-absorbing layer 3 is not included in the raw material for forming the p-type light-absorbing layer 3 but is diffused from the n-type layer 4 including Ga. When other elements are used during the formation of the n-type layer 4, these elements may also diffuse into the p-type light-absorbing layer 3. Diffusion of elements from an intermediate layer not shown in the drawings into the p-type light-absorbing layer 3 is also possible.

The compositional ratio mentioned above for the p-type light-absorbing layer (the layer mainly composed of a cuprous oxide compound) 3 is the overall compositional ratio of the p-type light-absorbing layer (the layer mainly composed of a cuprous oxide compound) 3. It is preferable that the compound compositional ratio described above for the p-type light-absorbing layer (the layer mainly composed of a cuprous oxide compound) 3 be met throughout the p-type light-absorbing layer (the layer mainly composed of a cuprous oxide compound) 3.

It is preferable that the p-type light-absorbing layer (the layer mainly composed of a cuprous oxide compound) 3 has a p⁺ type (p plus type) region on the first electrode 2 side.

It is preferable that the p-type light-absorbing layer (the layer mainly composed of a cuprous oxide compound) 3 has a p⁻ type (p minus type) region on the n-type layer 4 side and a p⁺ type (p plus type) region on the first electrode 2 side.

It is preferable that the thickness of the p-type light-absorbing layer 3 (the layer mainly composed of a cuprous oxide compound) is 2 µm or more and 10 µm or less; more preferably 2.5 µm or more and 7.0 µm or less. It is preferable that the p-type light-absorbing layer (the layer mainly composed of a cuprous oxide compound) 3 be the thickest layer among the layers included between the first electrode 2 and the second electrode 5. It is preferable that the p-type light-absorbing layer 3 (the layer mainly composed of a cuprous oxide compound) be the thickest semiconductor layer included in the solar cell 100.

It is preferable that the surface of the p-type light-absorbing layer 3 (the layer mainly composed of a cuprous oxide compound) on the n-type layer 4 side has fine unevenness. The average deviation of the surface roughness of the p-type light-absorbing layer (the layer mainly composed of a cuprous oxide compound) 3 on the n-type layer 4 side is preferably 50 nm or more; more preferably 50 nm or more and 500 nm or less; and further more preferably 55 nm or more and 300 nm or less. The fine unevenness is generated during the crystal growth of the cuprous oxide compound and therefore already exists before depositing Cu onto the layer mainly composed of a cuprous oxide compound.

It is preferable that the layer mainly composed of a cuprous oxide compound be formed by a sputtering method, for example. Specifically, a member on which the first electrode 2 is formed on the substrate 1 is heated to 300°C or more and 1000°C or less, and the oxygen partial pressure is within the range of 0.01 Pa or more and 4.8 Pa or less, and sputtering is performed at a rate within the range of 0.02 µm/min or more and 20 µm/min or less. From the viewpoint of forming a transparent, large-grained polycrystalline film, it is preferable that the oxygen partial pressure satisfies the following relationship when the deposition rate is d µm/min (However, when calculating the oxygen partial pressure, the unit of deposition rate is ignored.) : 0.20 × d Pa or more and 1.00 × d Pa or less (for example, in the case of high-temperature sputtering, 0.20 × d Pa or more and 0.50 × d Pa or less is preferable; in the case of low-temperature sputtering, 0.55 × d Pa or more and 1.00 × d Pa or less is preferable). It is also preferable that the heating temperature be higher than 550°C and 850°C or less. Elements represented by M1 can be added during film formation.

By forming the layer mainly composed of a cuprous oxide compound by the method described above, the layer mainly composed of a cuprous oxide compound with large-grained is formed. It is preferable that the p-type light-absorbing layer 3 (the layer mainly composed of a cuprous oxide compound) be a polycrystalline material including crystals of a cuprous oxide compound with a grain size 5 times or more the thickness of the p-type light-absorbing layer (the layer mainly composed of a cuprous oxide compound) 3.

When there is a Cu vacancy in the p-type light-absorbing layer 3, the carrier concentration increases. However, at the pn-junction, an increase in carrier concentration results in the n-type layer 4 side of the p-type light-absorbing layer 3 becoming p⁺ type, which is undesirable. A high carrier concentration on the n-type layer 4 side of the p-type light-absorbing layer 3 can lead to increasing discontinuity in the conduction band and increasing recombination due to the n-type layer 4 side acting as a carrier mobility barrier. Therefore, a locally high carrier concentration on the n-type layer 4 side of the p-type light-absorbing layer 3 leads to a decrease in FF (fill factor) and conversion efficiency. Repairing Cu vacancies improves the characteristics of the solar cell 110.

When the p-type light-absorbing layer 3 is polycrystalline of cuprous oxide compound, it is preferable that elements repairing Cu vacancies are present at grain boundaries included in the first region 3a (region from the n-type layer side surface of the p-type light-absorbing layer to the first electrode side with a depth of 100 nm). When the p-type light-absorbing layer 3 is polycrystalline of cuprous oxide compound, it is preferable for first elements to be present at grain boundaries included in the first region 3a.

Cu is preferable as the element that repairs Cu vacancies. Even when Cu is used as the element that repairs Cu vacancies, the number of oxygen atoms included in the cuprous oxide compound is preferably 0.48 or more and 0.56 or less, with respect to the copper atom count set to 1, both in the whole p-type light-absorbing layer 3 and in the first region 3a.

The carrier concentration in the first region 3a is preferably 1 × 10¹¹ cm⁻³ or more and 1 × 10¹⁵ cm⁻³ or less; more preferably, 1 × 10¹¹ cm⁻³ or more and 3 × 10¹⁴ cm⁻³ or less; and even more preferably, 1 × 10¹¹ cm⁻³ or more and 1 × 10¹⁴ cm⁻³ or less. When Cu vacancies are not repaired, the carrier concentration in the first region 3a tends to be 3 × 10¹⁵ cm⁻³ or more. The carrier concentration can be determined by device simulation (e.g., e-ARC method) based on current-voltage characteristics.

The carrier concentration in the second region 3b is preferably 1 × 10¹² cm⁻³ or more and 1 × 10¹⁵ cm⁻³ or less; more preferably, 1 × 10¹³ cm⁻³ or more and 7.5 × 10¹⁴ cm⁻³ or less; and even more preferably, 1 × 10¹⁴ cm⁻³ or more and 5 × 10¹⁴ cm⁻³ or less. Even when Cu vacancies are not repaired, the carrier concentration in the second region 3b tends to be within this range. When a large number of elements that repair Cu vacancies are included in the bulk (second region 3b), the carrier concentration of the entire p-type light-absorbing layer 3 will decrease. Therefore, it is preferable for the carrier concentration in the bulk (second region 3b) to be within the above range.

The carrier concentration in the first region 3a is preferably 0.0001 times or more and 3 times or less than the carrier concentration in the second region 3b; more preferably, 0.0001 times or more and 1 time or less; and even more preferably, 0.0001 times or more and 0.3 times or less. When Cu vacancies are not repaired, the carrier concentration in the first region 3a tends to be 3 times or more than the carrier concentration in the second region 3b.

In the second embodiment, Cu vacancies in the cuprous oxide compound are repaired with Cu. Since sputtered polycrystalline layers mainly composed of a cuprous oxide compound have high crystal quality, even before vacancy repair, the number of sites with missing Cu is small, making it difficult to evaluate Cu vacancy repair based on the ratio of Cu to oxygen. It is preferable to evaluate Cu vacancies on the surface of the p-type light-absorbing layer 3 in a similar manner as in the first embodiment, using PL intensity. Ideally, the p-type light-absorbing layer 3 in this second embodiment should also exhibit characteristics consistent with the photoluminescence spectrum described in the first embodiment.

Thinly deposited Cu adheres to the surface of the layer mainly composed of a cuprous oxide compound and diffuses into its interior. The layer formed by the diffusion of thinly deposited Cu into the layer mainly composed of a cuprous oxide compound becomes the p-type light-absorbing layer 3. In other words, the layer mainly composed of a cuprous oxide compound serves as a precursor to the p-type light-absorbing layer 3. When thinly deposited Cu remains in its elemental form, it will precipitate. When precipitated Cu exists between the p-type light-absorbing layer 3 and the n-type layer 4, the FF of solar cell 110 decreases compared to a solar cell without Cu vacancy repairing, resulting in a lower conversion efficiency.

By depositing a thin layer of Cu onto the sputtered polycrystalline layer mainly composed of a cuprous oxide compound so that it does not precipitate, small recess 3i will form on the surface of the p-type light-absorbing layer 3. The recess 3i differ from the ridge-like structures extending in the face direction (surface roughness as described in the first embodiment) that arise from grain boundaries on the surface of the p-type light-absorbing layer 3 or from the centers of crystals. The recess 3i are point-shaped depressions.

The average depth of the recess 3i (length in the stacking direction of the first electrode 2 and the p-type light-absorbing layer 3) is 10 nm or more and 80 nm or less; 20 nm or more and 70 nm or less; or 30 nm or more and 60 nm or less.

The maximum diameter of the recess 3i is 15 nm or more and 80 nm or less; 20 nm or more and 70 nm or less; or 30 nm or more and 60 nm or less.

The minimum diameter of the recess 3i is 10 nm or more. The maximum diameter of the recess 3i is 1 to 5 times the minimum diameter; 1 to 3 times the minimum diameter; or 1.1 to 3 times the minimum diameter. Furthermore, the depth of the recess 3i is 1 to 3 times the minimum diameter; or 1.1 to 3 times the minimum diameter.

The diameter of the recess 3i refers to the length of the opening (inner edge of the recess) on the surface side of the p-type light-absorbing layer 3.

The density of the recess 3i is 1 or more and 250 or less per 500 nm × 500 nm square area; 10 or more and 200 or less per 500 nm × 500 nm square area; or 15 or more and 100 or less per 500 nm × 500 nm square area.

The recess 3i is present on the p-type light-absorbing layer 3 but not on the layer mainly composed of a cuprous oxide compound.

The manufacturing method of the solar cell 110 according to the embodiment includes:
a) forming a layer mainly composed of a cuprous oxide compound onto the first electrode 2 by sputtering;
b) depositing Cu onto the surface (the surface where the n-type layer 4 is to be formed) opposite to the first electrode 2 side after the formation of the layer mainly composed of the cuprous oxide compound to obtain the p-type light-absorbing layer 3;
c) forming the n-type layer 4 on the surface of the p-type light-absorbing layer 3; and
d) forming a second electrode 5 on the n-type layer 4.

The layer mainly composed of the cuprous oxide compound is formed on the first electrode 2 by a sputtering method as described in the first embodiment. The first electrode 2 is provided on the substrate 1. The p-type light-absorbing layer (the layer mainly composed of the cuprous oxide compound) 3 formed by the sputtering method is polycrystalline.

Cu is preferably deposited on the surface opposite the first electrode 2 side of the layer mainly composed of the cuprous oxide compound. Sputtering or CVD are preferable methods for depositing Cu, with sputtering being more favorable.

It is preferable that the amount of Cu deposited on the layer mainly composed of the cuprous oxide compound is extremely small. The average thickness of the Cu deposited on the layer mainly composed of the cuprous oxide compound is preferably 0.02 nm or more and 0.08 nm or less; and more preferably 0.02 nm or more and 0.07 nm or less.

Since the amount of deposited Cu is minute, for example, conditions can be calculated to deposit Cu with a specific measurable thickness on a glass plate. Cu with an average thickness within the range of 0.02 nm to 0.07 nm can then be deposited using these calculated conditions.

When the amount of deposited Cu is too high (Cu has a larger average thickness), the recess 3i will not form and Cu tends to precipitate. Therefore, it is preferable to satisfy the above Cu average thickness conditions. When Cu precipitates, the FF of solar cell 110 becomes lower than when no Cu deposition occurs, resulting in lower conversion efficiency.

Even when the amount of deposited Cu is extremely small (Cu has a thinner average thickness than the range mentioned above), Cu will diffuse into the layer mainly composed of the cuprous oxide compound; however, the FF will be approximately the same as when no Cu is deposited. Therefore, it is preferable to satisfy the aforementioned average thickness conditions.

It is preferable that the Cu deposited on the layer mainly composed of the cuprous oxide compound be formed on the surface of the heated layer mainly composed of the cuprous oxide compound. The temperature (or stage temperature) of the surface of the layer mainly composed of cuprous oxide compound during Cu deposition is preferably 100 °C or more and 350 °C or less; more preferably 150 °C or more and 300 °C or less; and even more preferably 180 °C or more and 270 °C or less.

When the Cu deposition temperature is too high, Cu tends to agglomerate during deposition and diffusion into the layer mainly composed of the cuprous oxide compound becomes difficult. When diffusion into the layer mainly composed of the cuprous oxide compound is difficult, Cu precipitation occurs more easily. Therefore, it is preferable to satisfy the aforementioned temperature range.

When the temperature of Cu deposition is too low, Cu will not diffuse into the layer mainly composed of the cuprous oxide compound and will remain precipitated on the surface. In this case, it becomes difficult to repair the Cu vacancies in region 3a of the layer mainly composed of the cuprous oxide compound. Additionally, since Cu, a heterogenous phase of cuprous oxide, remains on the surface of the layer mainly composed of the cuprous oxide compound, FF decreases, leading to a lower conversion efficiency. Therefore, except when post-heating is performed as described above, it is preferable to satisfy the heating conditions for the surface temperature of the layer mainly composed of the cuprous oxide compound during Cu deposition.

It is considered that the recess 3i are formed during the process where Cu adheres to the surface of the layer mainly composed of the cuprous oxide compound and diffuses into its interior.

It is preferable to deposit Cu in a non-oxidizing atmosphere. Non-oxidizing atmospheres include, for example, nitrogen gas and argon gas.

An oxidation treatment may be performed before Cu deposition after sputtering of the cuprous oxide compound. The oxidation treatment oxidizes an extremely thin region on the surface of the film formed by sputtering. The following conditions are preferable for the oxidation conditions of the oxidation treatment.

### (FIRST CONDITION)

In the oxidation treatment, oxygen partial pressure is 5000 Pa or more and 200000 Pa or less, water vapor concentration is 9.4 × 10⁻¹ g/m³ or more and 2.5 × 10³ g/m³ or less, the treatment temperature is 40 °C or more and 150 °C or less, and the duration time is 5 sec or more and 150 min or less. The atmosphere (gas) for the oxidation treatment includes oxygen. Ozone with a concentration of 0.0% or more and 0.1% or less (maximum partial pressure: 1 Pa or less) may be included in the atmosphere of the oxidation treatment in the first, second, and fourth conditions. The atmosphere of the oxidation treatment may also include carbon monoxide, carbon dioxide, hydrocarbons, hydrogen, or other substances that are inevitably mixed in, such as those present in the atmosphere. For example, carbon monoxide, carbon dioxide, hydrocarbons, hydrogen, or other substances that are inevitably mixed in the atmosphere may be present in the oxidation treatment atmosphere at 5,000 ppm or less. The oxidation treatment atmosphere may further include inert gases such as nitrogen and argon, or hydrogen. Since the oxidation treatment atmosphere substantially does not contain oxidizing reactive gases other than oxygen and ozone, no reactive gas other than oxygen and ozone is introduced into the chamber where the oxidation treatment is performed. Therefore, it is preferable to introduce only oxygen gas and optionally ozone and/or inert gas into the chamber 21. The sum of the oxygen partial pressure and the partial pressure of inert gases (=([oxygen partial pressure]+[partial pressure of inert gas])/(total pressure of the gas excluding water vapor from the oxidation treatment atmosphere)) in the total pressure of the gas excluding water vapor from the oxidation treatment atmosphere is preferably 99.0% or more and 100% or less, and more preferably 99.3% or more and 100% or less (or 99.3% or more and 99.9% or less). Some preferable first conditions are described below.

During the oxidation treatment, the water vapor concentration is 9.4 × 10⁻¹ g/m³ or more and 2.5 × 10³ g/m³ or less, and during the oxidation treatment, one of the conditions of the duration time, the processing temperature and the oxygen pressure (partial pressure) are preferably satisfied. During the oxidation treatment, the duration time is 10 sec or more and less than 5 min, the processing temperature is 40 °C or more and less than 110 °C, the oxygen pressure is 50000 Pa or more and 100000 Pa or less. During the oxidation treatment, the duration time is 10 sec or more and less than 5 min, the processing temperature is 110 °C or more and 150 °C or less, the oxygen pressure is 15000 Pa or more and less than 50000 Pa. During the oxidation treatment, the duration time is 5 min or more and less than 10 min, the processing temperature is 40 °C or more and less than 80 °C, the oxygen pressure is 15000 Pa or more and less than 100000 Pa. During the oxidation treatment, the duration time is 10 min or more and less than 60 min, the processing temperature is 40 °C or more and less than 80 °C, the oxygen pressure is 15000 Pa or more and 40000 Pa or less. During the oxidation treatment, the duration time is 60 min or more less than 90 min, the processing temperature is 40 °C or more and 120 °C or less, the oxygen pressure is 15000 Pa or more and 35000 Pa or less. During the oxidation treatment, the duration time is 90 min or more and 150 min or less, the processing temperature is 40 °C or more and 60 °C or less, the oxygen pressure is 5000 Pa or more and 21000 Pa or less.

During the oxidation treatment, the oxygen pressure is 5000 Pa or more and 50000 Pa or less, the processing temperature is 50 °C or more and 150 °C or less, duration time is 5 min or more and 60 min or less, and the water vapor concentration is 9.4 × 10⁻¹ g/m³ or more and 2.5 × 10¹ g/m³ or less.

During the oxidation treatment, the processing temperature is 75 °C or more and 125 °C or less, the oxygen pressure is 5000 Pa or more and 100000 Pa or less, the duration time is 5 min or more and 45 min or less, the water vapor concentration is 9.4 × 10⁻¹ g/m³ or more and 2.5 × 10¹ g/m³ or less.

During the oxidation treatment, the processing temperature is 80 °C or more and 120 °C or less, the oxygen pressure is 5000 Pa or more and 100000 Pa or less, the duration time is 10 min or more and 45 min or less, the water vapor concentration 9.4 × 10⁻¹ g/m³ or more and 2.5 × 10¹ g/m³ or less.

During the oxidation treatment, the duration time is 10 sec or more and less than 5 min, the processing temperature is 110 °C or more and 150 °C or less, the oxygen pressure is 15000 Pa or more and less than 50000 Pa. During the oxidation treatment, the duration time is 5 min or more and less than 10 min, the processing temperature is 40 °C or more and less than 80 °C, the oxygen pressure is 15000 Pa or more and less than 100000 Pa. During the oxidation treatment, the duration time is 10 min or more and less than 60 min, the processing temperature is 40 °C or more and less than 80 °C, the oxygen pressure is 15000 Pa or more and 40000 Pa or less. During the oxidation treatment, the duration time is 90 min or more and 150 min or less, the processing temperature is 40 °C or more and 60 °C or less, the oxygen pressure is 5000 Pa or more and 21000 Pa or less.

### (SECOND CONDITION)

During the oxidation treatment, the oxygen pressure is 100 Pa or more and less than 5000 Pa, the processing temperature is 100 °C or more and 300 °C or less, and the duration time is 1 sec or more and 90 min or less. Hereinafter, several preferable conditions for the second condition will be described.

During the oxidation treatment, the oxygen pressure is 100 Pa or more and less than 5000 Pa, the processing temperature is 125 °C or more and 250 °C or less, and the duration time is 1 sec or more and 90 min or less.

During the oxidation treatment, the oxygen pressure is 300 Pa or more and 2000 Pa or less, the processing temperature is 180 °C or more and 250 °C or less, and the duration time is 5 sec or more and 45 min or less.

During the oxidation treatment, the oxygen pressure is 500 Pa or more and 2000 Pa or less, the processing temperature is 180 °C or more and 250 °C or less, and the duration time is 1 min or more and 30 min or less.

During the oxidation treatment, the oxygen pressure is 100 Pa or more and 2000 Pa or less, the processing temperature is 250 °C or more and 300 °C or less, and the duration time is 1 min or more and less than 10 min.

During the oxidation treatment, the oxygen pressure is 1000 Pa or more and less than 5000 Pa, the processing temperature is 200 °C or more and less than 250 °C, and the duration time is 1 min or more and less than 10 min.

During the oxidation treatment, the oxygen pressure is 1000 Pa or more and less than 5000 Pa, the processing temperature is 100 °C or more and 250 °C or less, and the duration time is 10 min or more and 60 min or less.

During the oxidation treatment, the oxygen pressure is 500 Pa or more and less than 5000 Pa, the processing temperature is 100 °C or more and 175 °C or less, and the duration time is 10 min or more and 30 min or less.

During the oxidation treatment, the oxygen pressure is 300 Pa or more and 1500 Pa or less, the processing temperature is 150 °C or more and 200 °C or less, and the duration time is 10 min or more and 30 min or less.

During the oxidation treatment, the oxygen pressure is 1000 Pa or more and less than 5000 Pa, the processing temperature is 100 °C or more and 150 °C or less, and the duration time is more than 60 min or more and 90 min or less.

### (THIRD CONDITION)

During the oxidation treatment, a partial pressure of ozone is 5 Pa or more and 200 Pa or less, the processing temperature is 273 K or more and 323 K or less, the duration time is 1 sec or more and 60 min or less. Some third condition will be described below.

During the oxidation treatment, the partial pressure of ozone is 7 Pa or more and 100 Pa or less, the processing temperature is 283 K or more and 308 K or less, the duration time is 1 min or more and 30 min or less.

During the oxidation treatment, the partial pressure of ozone is 10 Pa or more and 50 Pa or less, the processing temperature is 283 K or more and 308 K or less, the duration time is 1 min or more and 10 min or less.

### (FOUTH CONDITION)

During the oxidation treatment, the duration time is more than 1 hour or more and 1600 hour or less and an oxygen concentration is 5.0 × 10⁻⁸ g/L or more and 5.0 × 10⁻⁵ g/L or less. Hereinafter, several preferable conditions for the fourth condition will be described.

During the oxidation treatment, the duration time is more than 1 hour or more 1600 hour or less, the oxygen concentration is 5.0 × 10⁻⁸ g/L or more and 5.0 × 10⁻⁵ g/L or less, the water vapor concentration is 5.0 × 10⁻⁸ g/L or more and 5.0 × 10⁻⁵ g/L or less, and the processing temperature is 0 °C or more and 100 °C or less.

To prevent unintended oxidation reactions before and after the oxidation treatment, it is preferable to store the base member on which the layer mainly having the cuprous oxide compound has been sputter-deposited. After performing the oxidation treatment, the oxidized member is preferably stored in an atmosphere with an oxygen partial pressure of 50 Pa or less and a treatment temperature of 80 °C or less, more preferably 50 °C or less, or the n-type layer 4 film formation for solar cells is continued following the oxidation treatment. For example, before the n-type layer 4 is formed, the oxidized member can be stored in an atmospheric atmosphere (member temperature is the same) of 30 °C or less for 1 hour or less, preferably 30 min or less. Before performing the oxidation treatment, it is preferable to store it in an atmosphere with the oxygen partial pressure of 50 Pa or less and the treatment temperature of 280 °C or less, more preferably 50 °C or less, or in an atmospheric atmosphere of 30 °C or less for 1 hour or less, preferably 30 min or less. In these storage atmospheres, ozone may be included at a concentration of 0.1% or less with respect to the oxygen partial pressure.

In these storage atmospheres, the water vapor concentration (mass/volume) is preferably 5.0 × 10⁻⁸ g/L or more and 5.0 × 10⁻⁵ g/L or less, and more preferably 5.0 × 10⁻⁸ g/L or more and 4.0 × 10⁻⁵ g/L or less.

Preferably, the storage atmosphere does not contain plasma gas.

Before Cu deposition or after deposition and diffusing Cu, when the member on which the layer mainly having the cuprous oxide compound is sputtered on the base member is cooled after sputtering or oxidation treatment, it is preferable to cool it at a cooling rate of -10³ K/min or more and -0.1 K/min or less in an atmosphere with an oxygen partial pressure of 10⁻⁶ Pa or more and 10⁴ Pa or less. The temperature (or the temperature of the member after cooling) of the member on which the layer mainly having the cuprous oxide compound is sputtered on the base member after cooling is preferably -80 °C or more and 250 °C or less, for example.

Then, form the n-type layer 4 on the p-type light-absorbing layer 3, and further form the second electrode 5 on the n-type layer 4 to obtain a solar cell 120.

### (Third embodiment)

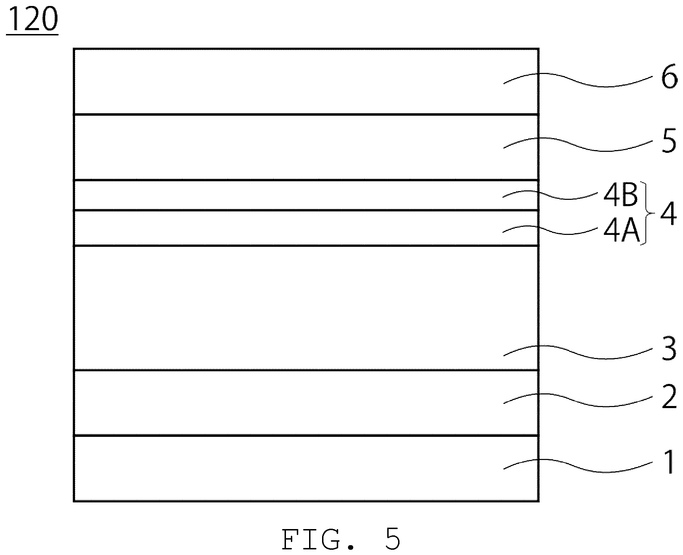

A third embodiment relates to a solar cell. FIG. 5 shows a schematic cross-sectional diagram of the solar cell 120 according to the third embodiment. The solar cell 120 shown in FIG. 5 includes a substrate 1, a first electrode 2, a p-type light-absorbing layer 3, an n-type layer 4 (a first n-type layer 4A and a second n-type layer 4B), and a second electrode 5. It is preferable that light enters the solar cell 120 from the side of the second electrode 5.

When transparent electrodes are used for the first electrode 2 and the second electrode 5, the solar cell 120 according to this embodiment is a transparent solar cell having a high transmittance for light in a wavelength band of 700 nm or more and 1200 nm or less.

When the solar cell 120 is a transparent solar cell using transparent electrodes for the first electrode 2 and the second electrode 5, the solar cell 120 according to this embodiment is preferably used on the top cell side (light incidence side).

The substrate 1, the first electrode 2, and the second electrode 5 of the third embodiment are common to those of the first embodiment and the second embodiment. For a common explanation regarding the substrate 1, the first electrode 2, and the second electrode 5 in the first embodiment through the third embodiment, descriptions of the substrate 1, the first electrode 2, and the second electrode 5 will be omitted.

The solar cell 120 (the solar cell 100, the solar cell 110) may include an intermediate layer including a low-refractive-index insulating layer such as SiO₂ or MgF₂ between the substrate 1 and the first electrode 2.

The solar cell 120 (the solar cell 100, the solar cell 110) may include an intermediate layer with a thickness of 0.1 nm or more and 50 nm or less between the first electrode 2 and the p-type light-absorbing layer 3, including one or more materials selected from the group consisting of SiO₂, Na₂O, CaO, B₂O₃, Al₂O₃, SiN, SiON, and MgO. The thickness of this intermediate layer may be uneven.

When the solar cell 120 (the solar cell 100, the solar cell 110) is non-transparent, the first electrode 2 may be a metal electrode such as Mo. The thickness of the first electrode 2 is not limited in this case.

The p-type light-absorbing layer 3 is overall a p-type semiconductor layer. The p-type light-absorbing layer 3 is provided on the first electrode 2. It is preferable that the p-type light-absorbing layer 3 is in direct contact with the first electrode 2. The p-type light-absorbing layer 3 is arranged between the first electrode 2 and the first n-type layer 4A. The p-type light-absorbing layer 3, which is directly in contact with the first n-type layer 4A, preferably forms a pn-junction with the first n-type layer 4A. The p-type light-absorbing layer 3 is preferably a compound semiconductor layer. More preferably, the p-type light-absorbing layer 3 comprises a cuprous oxide compound or a compound having a chalcopyrite structure.

The p-type light-absorbing layer 3 preferably comprises a cuprous oxide compound as the main component. It is preferable that the cuprous oxide compound has a cuprite structure, such as cuprous oxide (Cu₂O). The p-type light-absorbing layer 3 can be a layer in which a very thin layer of Cu is deposited on a layer mainly composed of a cuprous oxide compound and deposited-Cu is diffused into the interior of the layer mainly composed of the cuprous oxide compound.

The p-type light-absorbing layer 3 preferably comprises a compound having a chalcopyrite structure as the main component. As compounds having a chalcopyrite structure, the I-III-VI₂ compound and I-II-IV-VI₄ compound are preferable.

The thickness of the p-type light-absorbing layer 3 is preferably 500 nm or more and 10 µm or less; more preferably 750 nm or more and 7.0 µm or less. The p-type light-absorbing layer 3 is preferably the thickest layer among the layers included between the first electrode 2 and the second electrode 5. It is also preferable that the p-type light-absorbing layer 3 is the thickest among the semiconductor layers included in the solar cell 120.

It is preferable that the surface of the p-type light-absorbing layer 3 on the first n-type layer 4A side has fine unevenness. The average deviation of the surface roughness of the p-type light-absorbing layer 3 on the first n-type layer 4A side is preferably 50 nm or more; more preferably 50 nm or more and 500 nm or less; and even more preferably 55 nm or more and 300 nm or less.

The band gap of the p-type light-absorbing layer 3 is preferably 1.5 eV or more and 2.3 eV or less.

The carrier concentration (hole concentration) of the p-type light-absorbing layer 3 is preferably 1.0 × 10¹³ cm⁻³ or more and 1.0 × 10¹⁸ cm⁻³ or less; more preferably 1.0 × 10¹⁴ cm⁻³ or more and 1.0 × 10¹⁷ cm⁻³ or less; and even more preferably 2.0 × 10¹⁴ cm⁻³ or more and 5.0 × 10¹⁶ cm⁻³ or less. By satisfying the carrier concentration of the p-type light-absorbing layer 3 within the aforementioned range (or by making it difficult to increase the carrier concentration due to the fact that the p-type light-absorbing layer 3 has a wide band gap), at least one of the open-circuit voltage (Voc), short-circuit current density (Jsc), and fill factor (FF) can be improved, thereby contributing to an improvement in conversion efficiency (Eff).

It is preferable that 95 wt% or more and less than 100 wt% of the p-type light-absorbing layer 3 comprising a cuprous oxide compound is the cuprous oxide compound. More preferably, 98 wt% or more and less than 100 wt% of the p-type light-absorbing layer 3 is the cuprous oxide compound; and even more preferably 99 wt% or more and less than 100 wt% is the cuprous oxide compound. The p-type light-absorbing layer 3 can be composed entirely (100 wt%) of a cuprous oxide compound.

When the p-type light-absorbing layer 3 comprises a cuprous oxide compound, it may contain an additive element in an amount of 10% or less, preferably 5% or less, or 1% or less. The additive element for the cuprous oxide compound is preferably one or more elements selected from the group consisting of Cl, F, Br, I, Sn, Sb, Ag, Li, Na, K, Cs, Rb, Al, In, Zn, Mg, Ga, Si, Ge, N, P, B, Ti, Hf, Zr, and Ca.

The p-type light-absorbing layer 3 is preferably a semiconductor layer comprising a cuprous oxide compound. The p-type light-absorbing layer 3 is preferably polycrystalline of the cuprous oxide compound. A trace amount of one or more impurities of copper (Cu), cupric oxide (CuO), and copper hydroxide (Cu(OH)₂) may be included in the p-type light-absorbing layer 3.

The amount of oxygen atoms included in the cuprous oxide compound is preferably 0.48 or more and 0.56 or less when the number of copper atoms is set to 1. If there is more oxygen compared to copper (above range), the ratio of copper oxide included in the cuprous oxide compound increases, which narrows the band gap and reduces the transmittance of the p-type light-absorbing layer 3. If there is less oxygen compared to copper (above range), the amount of copper included in the cuprous oxide compound increases, which reduces the transmittance. Furthermore, if the ratio of oxygen to copper does not fall within the above range, it becomes difficult for the cuprous oxide compound to have a cuprous structure.

It is preferable that the p-type light-absorbing layer 3 has a low degree of heterogenous and has good crystallinity because this increases the transmittance of the p-type light-absorbing layer 3. The band gap of the p-type light-absorbing layer 3 can be adjusted by incorporating elements other than Cu and O, for example. It is preferable that the band gap BG3 of the p-type light-absorbing layer 3 is 2.0 eV or more and 2.2 eV or less. Within this range of band gaps, solar light can be efficiently utilized in both the top cell and bottom cell when a multi-junction solar cell utilizes a silicon-based absorbing layer as the bottom cell and the embodiment's solar cell as the top cell.

It is preferable that the p-type light-absorbing layer 3 includes Sn or/and Sb. The Sn or Sb in the p-type light-absorbing layer 3 may be added to the p-type light-absorbing layer 3, or it may originate from the first electrode 2. The Ga included in the p-type light-absorbing layer 3 is not included in the raw material for forming the p-type light-absorbing layer 3 but is diffused from the first n-type layer 4A or the second n-type layer 4B. When other elements are used during the formation of the first n-type layer 4A and the second n-type layer 4B, these elements may also diffuse into the p-type light-absorbing layer 3. Diffusion of elements from an intermediate layer not shown in the drawings into the p-type light-absorbing layer 3 is also possible. When the band gap of the p-type light-absorbing layer 3 is large, the carrier concentration tends to be low. Therefore, providing the first n-type layer 4A according to the embodiment is more effective.

The p-type light-absorbing layer 3 including the cuprous oxide compound is preferably formed by a
sputtering method, for example. Specifically, the member on which the first electrode 2 is formed on the substrate
1 is preferably heated to 300 °C or more and 1000 °C or less, and the deposition rate is set to 0.02 µm/min or more and 20 µm/min or less within an oxygen partial pressure range of 0.01 Pa or more and 4.8 Pa or less. From the viewpoint of forming a transparent and large-grained polycrystalline film, when the deposition rate is d (However, when calculating the oxygen partial pressure, the unit of deposition rate is ignored.), it is more preferable that the oxygen partial pressure satisfies 0.20 × d Pa or more and 1.00 × d Pa or less (for example, in the case of high-temperature sputtering, 0.20 × d Pa or more and 0.50 × d Pa or less is preferable, and in the case of low-temperature sputtering, 0.55 × d Pa or more and 1.00 × d Pa or less is preferable). The heating temperature is more preferably 550 °C or higher and 850°C or lower. An element M1 can be added during film formation.

By forming the p-type light-absorbing layer 3 by the method described above, large-grained cuprous oxide compound is formed. The p-type light-absorbing layer 3 preferably includes crystals of the cuprous oxide compound having a grain size that is five times or more the thickness of the p-type light-absorbing layer 3.

The p-type light-absorbing layer 3 of the third embodiment may also use the p-type light-absorbing layer 3 of the first embodiment or the p-type light-absorbing layer 3 of the second embodiment.

As the I-III-VI₂ compound, one or more compounds selected from the group consisting of CuGaSe₂, CuGaS₂, CuGaTe₂, CuInSe₂, CuInS₂, and CuInTe₂ are preferable. When multiple types of I-III-VI₂ compounds are included, they can be expressed as a compound such as Cu(Ga,In)Se₂, for example.

As the I-II-IV-VI₄ compound, Cu₂ZnSnS₄, Cu₂ZnSnSe₄, or Cu2ZnSn(S,Se)₄ are preferable.

When the p-type light-absorbing layer 3 includes a compound having a chalcopyrite structure, it is
preferable that 95 wt% or more and 100 wt% or less of the p-type light-absorbing layer 3 is a compound having a chalcopyrite structure. It is more preferable that 98 wt% or more and 100 wt% or less of the p-type light-absorbing layer 3 is a compound having a chalcopyrite structure, and it is even more preferable that 99 wt% or more and 100 wt% or less of the p-type light-absorbing layer 3 is a compound having a chalcopyrite structure. The p-type light-absorbing layer 3 can be composed entirely of 100 wt% of a compound having a chalcopyrite structure.

When the p-type light-absorbing layer 3 includes a compound having a chalcopyrite structure, it is preferable that the p-type light-absorbing layer 3 has high transmittance because the crystal quality is good with few heterogenous phases. By increasing the ratio of Ga included in the p-type light-absorbing layer 3 and/or increasing the ratio of S, the band gap BG3 of the p-type light-absorbing layer 3 can be adjusted to be higher. The band gap of the p-type light-absorbing layer 3 including a compound having a chalcopyrite structure is preferably 1.1 eV or more and 2.4 eV or less, and more preferably 1.5 eV or more and 2.2 eV or less. Within this range of band gaps, solar light can be efficiently utilized in both the top cell and the bottom cell when a multi-junction solar cell using Si as a light-absorbing layer for the bottom cell and the embodiments of the solar cell as the top cell.

When the p-type light-absorbing layer 3 includes a chalcopyrite structure compound (Ga and S are significantly high to very high, In and Se are low to very low), and the p-type light-absorbing layer 3 has a band gap of 1.6 eV or more and 2.4 eV or less, the solar cell 120 according to the embodiment can be used as a top cell solar cell. By using a Si solar cell as a bottom cell, both the top cell and the bottom cell can efficiently utilize sunlight. The band gap of the p-type light-absorbing layer 3 is large, so it is preferable to provide the first n-type layer 4A because conventional second n-type layers with good compatibility are low carrier concentration materials.

Chalcopyrite structure compounds can be formed on the first electrode 2 by, for example, a vapor deposition method such as a three-step method, a sputtering method, a nanoparticle printing method, and an electroplating method.

The first n-type layer 4A is an n-type semiconductor layer that transmits visible light. The first n-type layer 4A is arranged between the p-type light-absorbing layer 3 and the second n-type layer 4B. Preferably, the first n-type layer 4A is provided on the p-type light-absorbing layer 3. It is preferable that the first n-type layer 4A is in direct contact with the p-type light-absorbing layer 3. The surface of the first n-type layer 4A facing the p-type light-absorbing layer 3 is preferably in direct contact with the p-type light-absorbing layer 3. The first n-type layer 4A forms a pn junction with the p-type light-absorbing layer 3.

The second n-type layer 4B is an n-type semiconductor layer that transmits visible light. The second n-type layer 4B is arranged between the second n-type layer 4B and the second electrode 5. It is preferable that the second n-type layer 4B is provided on the first n-type layer 4A. It is preferable that the second n-type layer 4B is in direct contact with the first n-type layer 4A. The surface of the second n-type layer 4B facing the first n-type layer 4A is preferably in direct contact with the first n-type layer 4A. The second n-type layer 4B may be a single layer or a stack of layers with different compositions.

It is preferable that the band gap BG4 of the first n-type layer 4A is smaller than the band gap BG3 of the p-type light-absorbing layer 3. The band gap of the n-type layer, including the first n-type layer 4A, is preferably larger than the band gap of the p-type light-absorbing layer 3, considering band alignment and other factors. Through device simulations, it is found that by using a second n-type layer 4B with a large band gap as an n-type layer, and a first n-type layer 4A with a smaller band gap BG4 as an n-type layer, the conversion efficiency of the solar cell 120 can be improved.

It is preferable that the band gap BG4 of the first n-type layer 4A is smaller than the band gap BG3 of the p-type light-absorbing layer 3 and that the band gap BG5 of the second n-type layer 4B is larger than the band gap BG4 of the first n-type layer 4A, and it is preferable that the band gap BG5 of the second n-type layer 4B is larger than the band gap BG3 of the p-type light-absorbing layer 3. It is preferable that the relationship between the band gaps satisfies middle, small, large from the p-type light-absorbing layer 3 to the second n-type layer 4B.

Although the first n-type layer 4A, which forms a pn-junction with the p-type light-absorbing layer 3, satisfies the band gap mentioned above, it is expected that band discontinuity will occur and surface recombination will increase due to the relationship between the band gaps. However, device simulations revealed that Jsc actually increased, contributing to an improvement in conversion efficiency.

The difference (BG3-BG4) between the band gap BG4 of the first n-type layer 4A and the band gap BG3 of the p-type light-absorbing layer 3 is preferably 0.05 eV or more and 0.60 eV or less; more preferably 0.10 eV or more and 0.55 eV or less; and even more preferably 0.15 eV or more and 0.50 eV or less. When the band gap difference is small, the carrier concentration of the first n-type layer will decrease, reducing the effect of the first n-type layer. When the band gap difference is large, the offset between the conduction bands of the p-type light-absorbing layer 3 and the first n-type layer 4A will increase, making it difficult for electrons to flow. The flow of electrons becoming difficult results in a decrease in the current of the solar cell.

The difference (BG5-BG4) between the band gap BG5 of the second n-type layer 4B and the band gap BG4 of the first n-type layer 4A is preferably 3.0 eV or more and 4.8 eV or less, more preferably 3.1 eV or more and 3.9 eV or less, and even more preferably 3.2 eV or more and 4.0 eV or less. When the band gap difference is small, the carrier concentration of the first n-type layer will decrease, reducing the effect of the first n-type layer. When the band gap difference is large, the offset between the conduction bands of the first n-type layer 4A and the second n-type layer 4B will increase, making it difficult for electrons to flow. The flow of electrons becoming difficult results in a decrease in the current of the solar cell.

It is preferable that the difference (BG5-BG4) between the band gap BG5 of the second n-type layer 4B and the band gap BG4 of the first n-type layer 4A be larger than the difference (BG3-BG4) between the band gap BG4 of the first n-type layer 4A and the band gap BG3 of the p-type light-absorbing layer 3. The difference (BG5-BG4) between the band gap BG5 of the second n-type layer 4B and the band gap BG4 of the first n-type layer 4A is preferably 1.5 times to 30 times the difference (BG3-BG4) between the band gap BG4 of the first n-type layer 4A and the band gap BG3 of the p-type light-absorbing layer 3; more preferably 2.0 times to 20 times; and even more preferably 2.5 times to 15 times. In other words, it is preferable that the band gap BG4 of the first n-type layer 4A be closer to the band gap BG3 of the p-type light-absorbing layer 3 than the band gap BG5 of the second n-type layer 4B, and the difference between the band gap BG4 of the first n-type layer 4A and the band gap BG3 of the p-type light-absorbing layer 3 is relatively smaller compared to the difference between the band gap BG4 of the first n-type layer 4A and the band gap BG5 of the second n-type layer 4B.

It is preferable that the carrier concentration (electron concentration) of the first n-type layer 4A be higher than the carrier concentration (hole concentration) of the p-type light-absorbing layer 3. The carrier concentration (electron concentration) of the first n-type layer 4A is preferably 100 times to 1000000 times the carrier concentration (hole concentration) of the p-type light-absorbing layer 3, more preferably 500 times to 500000 times, and even more preferably 1000 times to 100000 times. It is considered that using the first n-type layer 4A can compensate for the low carrier concentration caused by the wide band gap semiconductor which tends to have a low carrier concentration.

When the cuprous oxide compound is included in the p-type light-absorbing layer 3, it is preferable that the band gap BG4 of the first n-type layer 4A is 1.4 eV or more and less than 2.1 eV; more preferably 1.45 eV or more and 2.0 eV or less; and even more preferably 1.5 eV or more and 1.9 eV or less.

When the cuprous oxide compound is included in the p-type light-absorbing layer 3, Cu₃N or amorphous silicon are preferable for the first n-type layer 4A. In addition to Cu₃N and amorphous silicon, the first n-type layer 4A may include elements included in the p-type light-absorbing layer 3 and the second n-type layer 4B.

It is preferable that 95 wt% or more and 100 wt% or less of the first n-type layer 4A, when the cuprous oxide compound is included in the p-type light-absorbing layer 3, is Cu₃N or amorphous silicon. It is more preferable that 98 wt% or more and 100 wt% or less of the first n-type layer 4A is Cu₃N or amorphous silicon; and even more preferably 99 wt% or more and 100 wt% or less is Cu₃N or amorphous silicon. The first n-type layer 4A can be composed entirely of Cu₃N or amorphous silicon.

From the viewpoint of supplementing Cu vacancy in the first region 3a of the p-type light-absorbing layer 3 including a cuprous oxide compound, it is preferable to use Cu₃N for the first n-type layer 4A in a solar cell 120 using the p-type light-absorbing layer 3 including a cuprous oxide compound.

When the band gap BG3 of the p-type light-absorbing layer 3 including a chalcopyrite structure compound is 1.6 eV or more and less than 2.4 eV, Cu₃N, CdTe, or amorphous silicon are preferable for the first n-type layer 4A in the solar cell 120 using the p-type light-absorbing layer 3. In addition to Cu3N, CdTe, or amorphous silicon, the first n-type layer 4A may include elements included in the p-type light-absorbing layer 3 and the second n-type layer 4B.

When the band gap BG3 of the p-type light-absorbing layer 3 including a chalcopyrite structure compound is 1.6 eV or more and less than 2.4 eV, it is preferable that 95 wt% or more and 100 wt% or less of the first n-type layer 4A in a solar cell 120 using the p-type light-absorbing layer 3 is Cu₃N, CdTe, or amorphous silicon. It is more preferable that 98 wt% or more and 100 wt% or less of the first n-type layer 4A is Cu₃N, CdTe, or amorphous silicon; and even more preferably 99 wt% or more and 100 wt% or less is Cu₃N, CdTe, or amorphous silicon. The first n-type layer 4A can be composed entirely of Cu₃N, CdTe, or amorphous silicon.

When the band gap BG3 of the p-type light-absorbing layer 3 including a chalcopyrite structure compound is 1.6 eV or more and less than 2.4 eV, Cu3N, CdTe, or amorphous silicon are preferable for the first n-type layer 4A in a solar cell 120 using the p-type light-absorbing layer 3. The first n-type layer 4A may include elements included in the p-type light-absorbing layer 3 and the second n-type layer 4B in addition to Cu3N, CdTe, or amorphous silicon.

When the band gap BG3 of the p-type light-absorbing layer 3 including a chalcopyrite structure compound is 1.6 eV or more and less than 2.4 eV, it is preferable that the band gap BG4 of the first n-type layer 4A in the solar cell 120 is 1.4 eV or more and less than 2.1 eV. More preferably, the band gap BG4 is 1.45 eV or more and 2.0 eV or less, and even more preferably 1.5 eV or more and 1.9 eV or less. However, the band gap BG4 of the first n-type layer 4A should always be smaller than the band gap BG3 of the p-type light-absorbing layer.

The thickness of the first n-type layer 4A is preferably 1 nm or more and 50 nm or less; more preferably 2 nm or more and 40 nm or less; and even more preferably 3 nm or more and 30 nm or less.

The second n-type layer 4B in a solar cell 120 using the p-type light-absorbing layer 3 including cuprous oxide compound preferably includes one or more selected from the group consisting of an oxide including Ga and arbitrarily including an element represented by M2, an oxide including Zn and an element represented by M3, an oxide including Ti and arbitrarily including an element represented by M4, and titanium strontium oxide arbitrarily including an element represented by M4. The element M2 represents one or more elements selected from the group consisting of H, Sn, Sb, Cu, Ag, Li, Na, K, Cs, Rb, Al, In, Zn, Mg, Si, Ge, N, B, Ti, Hf, Zr, Ca, Ce, La, Pr, and Nd. The element M3 represents one or more elements selected from the group consisting of Sn, Sb, Hf, Zr, Si, Al, and Mg. M4 represents one or more elements selected from the group consisting of Nb, Ta, Mo, and W.

Examples of preferred second n-type layer 4B in a solar cell 120 using a p-type light-absorbing layer 3 including cuprous oxide include: a layered body of a Ga- including oxide layer (on the first n-type layer 4A side) arbitrarily including an element represented by M2 and a Zn-including oxide layer (on the second electrode 5 side); a Zn- including oxide layer including an element represented by M3; or a layered body with a Ga- including oxide layer (on the first n-type layer 4A side) arbitrarily including an element represented by M2, a Zn- including oxide layer (intermediate), and a Ti- including oxide layer or titanium strontium oxide layer (on the second electrode 5 side) arbitrarily including an element represented by M4.

The second n-type layer 4B in a solar cell 120 using the p-type light-absorbing layer 3 including a chalcopyrite structure compound is, for example, CdS, Zn(O,S), ZnS, ZnMgO, or In₂S₃, but not limited thereto.

The carrier concentration (electron concentration) of the first n-type layer 4A is preferably 2.0 × 10¹⁶ cm⁻³ or more and 1.0 × 10²⁰ cm⁻³ or less; more preferably 5.0 × 10¹⁶ cm⁻³ or more and 5.0 × 10¹⁹ cm⁻³ or less; and even more preferably 1.0 × 10¹⁷ cm⁻³ or more and 1.0 × 10¹⁹ cm⁻³ or less.

The second n-type layer 4B is the main n-type layer in the solar cell 120. The thickness of the second n-type layer 4B is preferably 1 nm or more and 50 nm or less, more preferably 2 nm or more and 40 nm or less, and even more preferably 3 nm or more and 30 nm or less.

The first n-type layer 4A can be formed by methods such as atomic layer deposition (ALD), sputtering, pulsed laser deposition (PLD), chemical vapor deposition (CVD), and chemical bath deposition (CBD). The first n-type layer 4A is mainly crystalline but may contain amorphous content. A thin Cu layer may be formed on the surface of the p-type light-absorbing layer 3, and Cu may be nitrided in an atmosphere including ammonia and oxygen to form Cu₃N.

The second n-type layer 4B can also be formed by methods such as atomic layer deposition, sputtering, pulsed laser deposition, chemical vapor deposition, and chemical bath deposition. The second n-type layer 4B is mainly crystalline but may contain amorphous content.

It is preferable that the valence band is discontinuous from the p-type light-absorbing layer 3 to the second n-type layer 4B in the solar cell 120 including the first n-type layer 4A.

An oxide including one or more elements selected from the group consisting of Al, Hf, Zr, and B may be present as islands between the p-type light-absorbing layer 3 and the first n-type layer 4A.

The n-type layer 4 of the third embodiment may be used in the first and second embodiments.

The second electrode 5 is provided on the second n-type layer 4B. The second electrode 5 is an electrode on the side of the second n-type layer 4B that has light transmittance with respect to visible light. It is preferable that the second electrode 5 be provided on the second n-type layer 4B. A transparent conductive oxide film is preferably used for the second electrode 5. The oxide transparent conductive film used in the second electrode 5 is preferably one or more semiconductor conductive films selected from the group consisting of doped tin oxide, indium tin oxide, aluminum-doped zinc oxide, boron-doped zinc oxide, gallium-doped zinc oxide, indium-doped zinc oxide, titanium-doped indium oxide, indium gallium zinc oxide, and hydrogen-doped indium. The dopant for a film such as tin oxide is not particularly limited, but one or more selected from the group consisting of In, Si, Ge, Ti, Cu, Sb, Nb, Ta, W, Mo, F, and Cl can be used. The second electrode 5 may include mesh-shaped or line-shaped electrodes for reducing the resistance of the oxide transparent conductive film. The mesh-shaped or line-shaped electrodes are not particularly limited and can include Mo, Au, Cu, Ag, Al, Ta, or W. Graphene can also be used in the second electrode 5. It is preferable that the graphene be laminated with silver nanowires.

The thickness of the second electrode 5 is determined by cross-sectional observation using an electron microscope or a step meter.

The thickness of the second electrode 5 is preferably 30 nm or more and 2 µm or less, more preferably 30 nm or more and 1000 nm or less, and even more preferably 30 nm or more and 500 nm or less.

The second electrode 5 is preferably formed by, for example, ALD (atomic layer deposition) or sputtering.

The composition of the solar cell 120 can be confirmed, for example, by analyzing analysis spots A1 to A9 shown in FIG. 2. Analysis is performed at the center of each analysis spot along the thickness direction.

For example, the carrier concentration of each layer included in the solar cell 120 can be calculated by measuring the Hall effect using an AC Hall effect measuring device manufactured by Toho Technica Co., Ltd. under atmospheric conditions at room temperature (25 °C).

For example, the band gap of each layer included in the solar cell 120 can be determined by measuring the absorbance with a spectrophotometer.

Next, several examples of manufacturing methods for the configuration of the solar cell 120 will be shown.

The first example is a solar cell having the following configuration:
The substrate 1: Ultra clear glass
The first electrode 2: A laminated body of ITO (ITO side) and ATO (p-type light-absorbing layer 3 side)
The p-type light-absorbing layer 3: Cu₂O
The first n-type layer 4A: Cu₃N
The second n-type layer 4B: Ga₂O₃ (first n-type layer 4A side) and ZTO (ZnO including titanium oxide, second
   electrode 5 side)
The second electrode 5: AZO

First, ITO (In:Sn = 80:20, film thickness 150 nm) and ATO (Sn:Sb = 98:2, film thickness 100 nm) are deposited as the first electrode 2 on the ultra clear glass by the CVD method. A Cu₂O film with a thickness of 6.6 µm is formed on the ATO by sputtering in an atmosphere of nitrogen, oxygen and argon gas. Then, a 10 nm thick Cu₃N film is deposited on the Cu₂O film by sputtering. Next, as the second n-type layer 4B, a 15 nm thick Ga₂O₃ film is deposited on the Cu₃N by the ALD method, followed by deposition of 14 nm ZnSnO (Zn:Sn = 80:20) on the Ga₂O₃. Then, AZO (Al content in Zn being 5%) with a thickness of 40 nm is formed on the ZnSnO by the ALD method as the second electrode 5 to obtain the solar cell 120. Alternatively, a 10 nm thick Cu film can be formed on the Cu₂O during the final stage of the sputtering process for the p-type light-absorbing layer 3 and then heated in an atmosphere including ammonia and oxygen to dehydrogenate ammonia and nitride the Cu film with active nitrogen species generated thereby. This forms Cu₃N on the Cu₂O.

The second example is a solar cell having the following configuration:
The substrate 1: Ultra clear glass
The first electrode 2: ITO (ITO side) and ATO (p-type light-absorbing layer 3 side)
The p-type light-absorbing layer 3: Cu₂O
The first n-type layer 4A: Amorphous silicon
The second n-type layer 4B: ZTO
The second electrode 5: AZO

First, ITO (In:Sn = 80:20, film thickness 150 nm) and ATO (Sn:Sb = 98:2, film thickness 100 nm) are deposited on the ultra clear glass as the first electrode 2 by the CVD method. A Cu₂O film with a thickness of 5 µm is formed on the ATO by sputtering in an atmosphere of nitrogen, oxygen and argon gas. Then, a 10 nm thick amorphous silicon film is deposited on the Cu₂O film using plasma CVD with silane gas. Next, as the second n-type layer 4B, a 30 nm thick ZnSnO (Zn:Sn = 80:20) film is deposited on the amorphous silicon. Then, AZO (Al content in Zn being 5%) with a thickness of 40 nm is formed on the ZnSnO by the ALD method as the second electrode 5 to obtain the solar cell 120.

The third example is a solar cell having the following configuration:
The substrate 1: Ultra clear glass
The first electrode 2: Mo
The p-type light-absorbing layer 3: CuGaSe₂
The first n-type layer 4A: CdTe
The second n-type layer 4B: CdS
The second electrode 5: FTO

First, a 1 µm thick Mo film is deposited as the first electrode 2 on the ultra clear glass by DC magnetron sputtering. Then, a 2 µm thick CuGaSe₂ film is deposited as the p-type light-absorbing layer 3 on the Mo film using a three-step method. Next, a 10 nm thick CdTe film is deposited as the first n-type layer 4A on the CuGaSe₂ by sputtering. Then, a 30 nm thick CdS film is deposited as the second n-type layer 4B on the CdTe using CBD. Finally, a 100 nm thick FTO (Sn:F = 95:5) film is formed on the CdS to obtain the solar cell 120 by CVD.

The fourth example is a solar cell having the following configuration:
The substrate 1: Ultra clear glass
The first electrode 2: ITO
The p-type light-absorbing layer 3: Cu(Ga,In) (S,Se)₂
The first n-type layer 4A: Cu₃N
The second n-type layer 4B: CdS
The second electrode 5: FTO

First, a 150 nm thick ITO film (In:Sn = 80:20) is deposited as the first electrode 2 on the ultra clear glass by CVD. Then, a 2 µm thick Cu(Ga,In) (S,Se)₂ film is deposited as the p-type light-absorbing layer 3 on the ITO using a three-step method. Next, a 10 nm thick Cu₃N film is deposited as the first n-type layer 4A on the Cu(Ga,In)(S,Se)₂ by sputtering. Then, a 30 nm thick CdS film is deposited as the second n-type layer 4B on the Cu₃N using CBD. Finally, a 100 nm thick FTO (Sn:F = 95:5) film is formed on the CdS to obtain the solar cell 120 by CVD.

### (FOURTH EMBODIMENT)

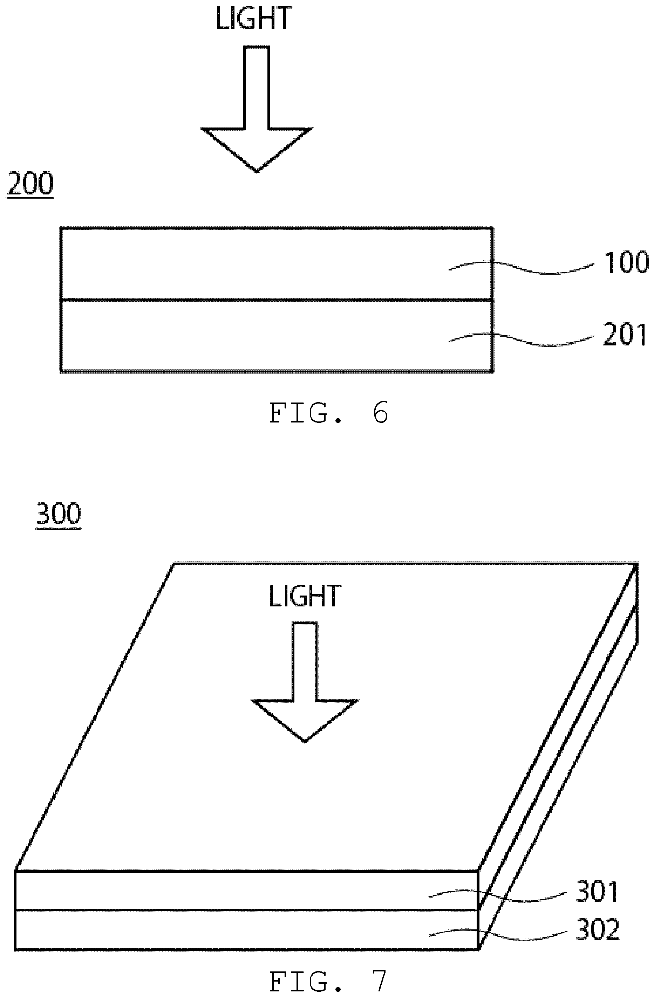

A fourth embodiment relates to a multi-junction solar cell. FIG. 6 shows a cross-sectional diagram of the multi-junction solar cell according to the fourth embodiment. The multi-junction solar cell 200 shown in FIG. 6 has a first solar cell (solar cell 100) according to the first embodiment (or the second embodiment solar cell 110, or the third embodiment solar cell 120) on the light incident side and a second solar cell 201. The band gap of the light-absorbing layer of the second solar cell 201 is smaller than the band gap of the p-type light-absorbing layer 3 of the first embodiment's solar cell 100 (or the p-type light-absorbing layer 3 of the second embodiment's solar cell 110, or the third embodiment's solar cell 120). Note that the multi-junction solar cell 200 according to this embodiment may also include three or more solar cells joined together.

Since the band gap of the p-type light-absorbing layer (cuprous oxide) 3 in the first solar cell 100 according to the fourth embodiment (or the second embodiment solar cell 110 or the third embodiment solar cell 120) is approximately 2.0 eV or more and 2.2 eV or less, it is preferable that the band gap of the light-absorbing layer of the second solar cell 201 be 1.0 eV or more and 1.6 eV or less. As the light-absorbing layer of the second solar cell 201, one or more compound semiconductor layers selected from the group consisting of CIGs-based and CdTe-based systems with a high In content ratio, crystalline silicon, and perovskite-type compounds are preferable.

### (FIFTH EMBODIMENT)

A fifth embodiment relates to a solar cell module. FIG. 7 shows a perspective diagram of the solar cell module 300 according to the fifth embodiment. The solar cell module 300 includes first solar cell module 301 including a plurality of the solar cells 100 or includes first solar cell module 301 including a plurality of multi-junction solar cells. The solar cell module 300 can be installed on the light incident side of an existing solar cell installation.

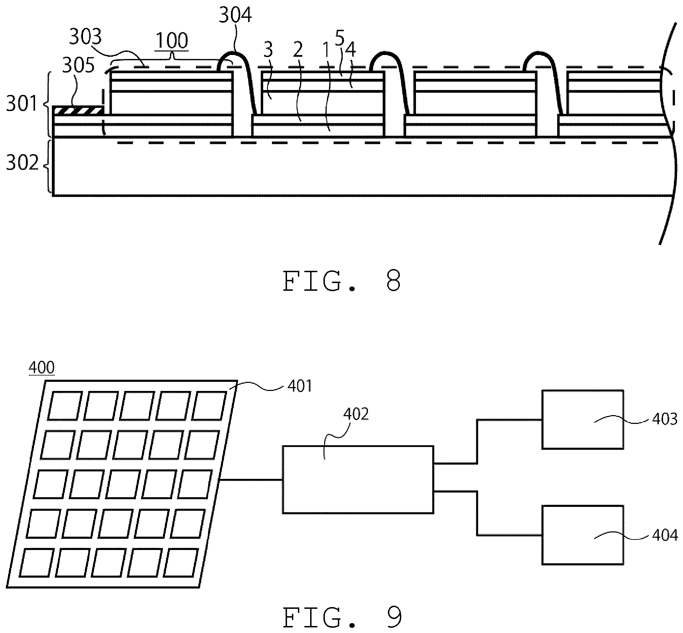

FIG. 8 shows a perspective diagram of the solar cell module 310 according to the fifth embodiment. The solar cell module 310 is a solar cell module (a tandem solar cell module), stacked with a first solar cell module 301 including a plurality of solar cells 100 and a second solar cell module 302. The first solar cell module 301 is on the light incident side. It is preferable to use the second solar cell 201 for the second solar cell module 302.

### (Sixth Embodiment)

A sixth embodiment relates to a photovoltaic power generation system. The solar cell module according to the fifth embodiment can be used as a generator in the photovoltaic power generation system of the sixth embodiment. The photovoltaic power generation system of the embodiment uses a solar cell module to generate electricity and includes, specifically, a solar cell module for generating electricity, a converting element for converting electric power, and a storage element for storing generated electricity or a load for consuming generated electricity. FIG. 9 shows a schematic diagram of the photovoltaic power generation system 400 according to the embodiment. The photovoltaic power generation system in FIG. 9 includes a solar cell module 401 (300), a converter 402, a battery 403, and a load 404. Either the battery 403 or the load 404 may be omitted. The load 404 can also be configured to utilize the electrical energy stored in the battery 403. The converter 402 is a device including circuits or elements for power conversion such as voltage transformation and DC-AC conversion, such as a DC-DC converter, a DC-AC converter, an AC-AC converter. The configuration of the converter 402 can be suitably adopted depending on the generation voltage and the configurations of the battery 403 and the load 404.

The solar cell module 401 receives sunlight and generates electricity, which is converted by the converter 402 and stored in the battery 403 or consumed by the load 404. It is preferable that a sun-tracking drive device for always directing the solar cell module 401 toward the sun, or a concentrator for collecting sunlight, be provided to the solar cell module 401 to improve power generation efficiency. As the load 404, an electrolytic device for performing water electrolysis, CO2 electrolysis, ammonia electrolysis, ammonia synthesis, etc., can be used.

It is preferable that the solar power generation system 400 be used for real estate such as residences, commercial facilities and factories, or movables such as vehicles, aircraft and electronic devices. By using a high-efficiency solar cell of the embodiment in the solar cell module, an increase in power generation amount can be expected.

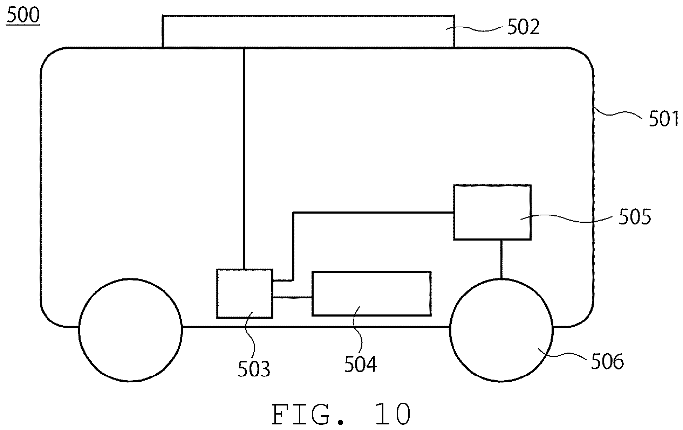

As an example of use of the solar power generation system 400, a vehicle will be described. FIG. 10 shows a schematic diagram of the configuration of a vehicle 500. The vehicle 500 shown in FIG. 10 includes a car body 501, a solar cell module 502, a power converter 503, a storage battery 504, and a motor 505 and tires (wheels) 506. Electricity generated by the solar cell module 502 installed on the upper part of the car body 501 is converted by the power converter 503 and charged to the storage battery 504 or consumed as load by the motor 505 or the like. The vehicle 500 can be driven by rotating the tires (wheels) 506 by the motor 505 using electricity supplied from the solar cell module 502 or the storage battery 504. The solar cell module 502 may be composed solely of a first solar cell module, such as the solar cell 100 (or the solar cell 110 of the second embodiment, or the solar cell 120 of the third embodiment). When adopting a transparent solar cell module 502, it is preferable to use the solar cell module 502 as a power generating window not only on the upper part of the car body 501 but also on the side of the car body 501.

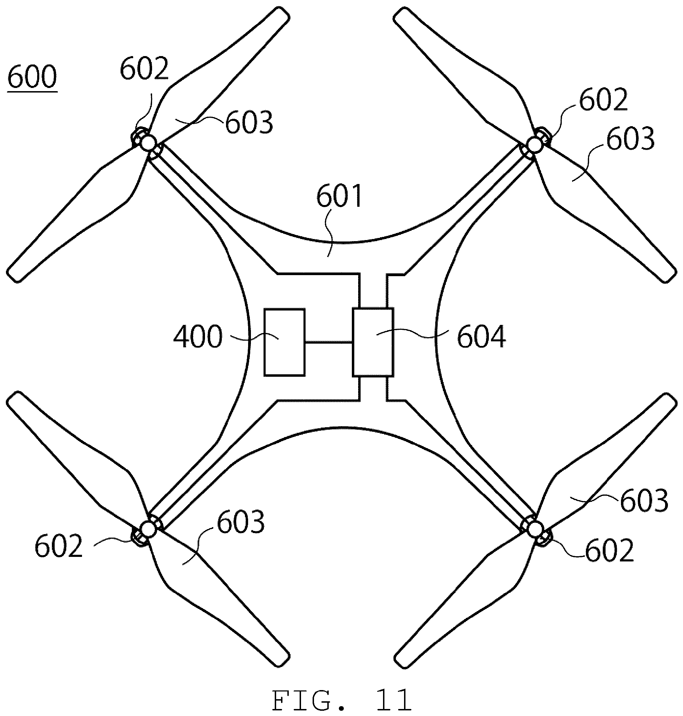

As an example of use of the solar power generation system 400, a drone (quadcopter) will be described. The drone uses the solar cell module 401. A configuration of the drone according to this embodiment will be briefly explained using a schematic diagram of a drone 600 shown in FIG. 11. The drone 600 includes a solar cell module 601, a frame 602, motors 603, rotors 604 and a control unit 605. The solar cell module 601, the motors 603, the rotors 604 and the control unit 605 are arranged in the frame 602. The control unit 605 converts and adjusts the output of electricity from the solar cell module 601. The motor 603 rotates the rotor 604 using electricity output from the solar cell module 601. By providing this drone 600 with the solar cell module 601 according to the embodiment, a drone that can fly using more power can be provided.

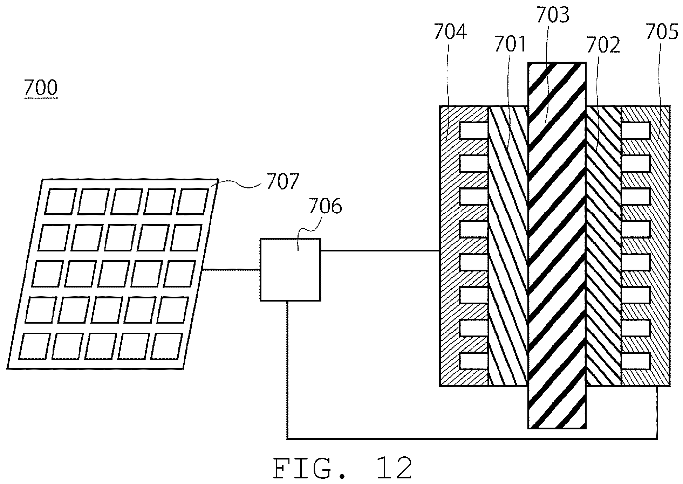

As an example of use of the solar power generation system 400, an electrolytic apparatus will be described. The electrolytic apparatus uses the solar cell module 401. The electrolytic apparatus according to the embodiment is used for water electrolysis, synthesis of ammonia by electrolysis, electrolysis of ammonia to generate hydrogen, electrolysis of CO₂ to synthesize CO or hydrocarbons and so on. FIG. 12 shows a schematic diagram of an electrolytic apparatus 700. The electrolytic apparatus 700 includes an anode 701, a cathode 702, a diaphragm 703, an anode current collector 704, a cathode current collector 705, a power converter 706 and a solar cell module 707. The power converter 706 converts the electricity generated by the solar cell module 707 into a power source suitable for the electrolytic reaction. The configuration of the electrolytic apparatus 700 is in the form of using the anode 701, the cathode 702, the diaphragm 703, the anode current collector 704 and the cathode current collector 705 as a load 404 for the solar power generation system 400. The electrolytic reaction is performed by the anode 701, the cathode 702, the diaphragm 703, the anode current collector 704 and the cathode current collector 705. It is preferable to use a stack in which the configurations for performing the electrolytic reaction are stacked.

Hereinafter, this invention will be described more concretely based on embodiments, but this invention is not limited to the following embodiments. Embodiments A through D relate to the first embodiment. Embodiments E and F relate to the second embodiment. Embodiments G through I relate to the third embodiment.

### (Embodiment A)

### (Embodiment A1)

On a glass substrate 1, as the first electrode 2 on the side in contact with the glass, ITO (In:Sn = 80:20, film thickness 150 nm) and ATO (Sn:Sb=98:2, film thickness 100 nm) are deposited. On the ATO, a Cu₂O layer with a thickness of 6 µm is formed as the p-type light-absorbing layer 3 by sputtering in an oxygen and argon gas atmosphere. After forming the p-type light-absorbing layer 3, a small amount of Cu is deposited. Then, a Ga₂O₃ film with a thickness of 10 nm is formed as the n-type layer 4. Then, AZO (ZnO:Al) with a thickness of 0.1 µm is deposited to form the solar cell 100.

Under a light source simulating AM 1.5G, the illuminance is adjusted so that the reference Si cell becomes 1 sun under the light source. The measurement is carried out at atmospheric pressure with an indoor temperature of 25 °C. The voltage is swept to measure the short-circuit current density Jsc (current divided by the cell area). On a graph with voltage on the horizontal axis and current density on the vertical axis, the point where the graph intersects the horizontal axis is the open-circuit voltage Voc. When the product of the voltage and short-circuit current density is maximized on the measurement curve, these values are defined as Vmpp and Jmpp (maximum power point), respectively. Then, FF = (Vmpp × Jmpp) / (Voc × Jsc) yields the fill factor. The conversion efficiency can be calculated using Eff. = Voc × Jsc × FF.

The emission intensity is evaluated as follows:
A: maximum value of the emission intensity in the wavelength range of 900 nm or more and 900 nm or less in the first region is 0 times and 2 times or less the maximum value of the emission intensity in the first wavelength range in the second region, and
B: maximum value of the emission intensity in the wavelength range of 900 nm or more and 900 nm or less in the first region is greater than 2 times the maximum value of the emission intensity in the first wavelength range.
The evaluation of emission intensity is common to Examples A through D.

The transmissivity is evaluated as follows:
A: when the transmittance of light in the wavelength range of 700 nm or more and 1000 nm or less is 75% or more,
B: when the transmittance of light in the wavelength range of 700 nm or more and 1000 nm or less is 70% or more and less than 75%, and
C: when the transmittance of light in the wavelength range of 700 nm or more and 1000 nm or less is less than 70%.
The evaluation of transmissivity is common to Examples A through D.

Jsc is evaluated as follows:
A: when Jsc of the example is 1.01 times or more compared to Jsc of the reference example,
B: when Jsc of the example is 1.0 times or more and less than 1.01 times compared to Jsc of the reference example,
C: when Jsc of the example is less than 1.0 times compared to Jsc of the reference example.
The evaluation of Jsc is common to Examples A through D.

Voc is evaluated as follows:
A: when Voc of the example is 1.02 times or more compared to Voc of the reference example,
B: when Voc of the example is 1.00 times or more and less than 1.02 times compared to Voc of the reference example, and
C: when Voc of the example is less than 1.00 times compared to Voc of the reference example.
The evaluation of Voc is common to Examples A through D.

FF is evaluated as follows:
A: when FF of the example is 1.01 times or more compared to FF of the reference example,
B: when FF of the example is 1.00 times or more and less than 1.01 times compared to FF of the reference example, and
C: when FF of the example is less than 1.00 times compared to FF of the reference example.
The evaluation of FF is common to Examples A through D.

Conversion efficiency is evaluated as follows:
A: when conversion efficiency of the example is 1.04 times or more compared to conversion efficiency of the reference example,
B: when conversion efficiency of the example is 1.00 times or more and less than 1.04 times compared to conversion efficiency of the reference example, and
C: when conversion efficiency of the example is less than 1.00 times compared to conversion efficiency of the reference example.
The evaluation of conversion efficiency is common to Examples A through D.

### (Comparative Example A1)

ITO (In:Sn = 80:20, film thickness 150 nm) and ATO (Sn:Sb=98:2, film thickness 100 nm) are deposited on the glass substrate 1 as the first electrode 2 on the side in contact with the glass. On the ATO, a Cu₂O layer with a thickness of 6 µm is formed as the p-type light-absorbing layer 3 by sputtering in an oxygen and argon gas atmosphere. After forming the p-type light-absorbing layer 3, a Ga₂O₃ film with a thickness of 10 nm is formed as the n-type layer 4 directly above the p-type light-absorbing layer 3. Then, AZO (ZnO:Al) with a thickness of 0.1 µm is deposited to form a solar cell. The solar cell in Comparative Example A1 is evaluated in the same manner as in Example A1.

### (Example A2)

A solar cell is obtained in the same manner as in Example A1 except that Cu is not deposited but Zn is deposited after forming the p-type light-absorbing layer 3. The solar cell in Example A2 is evaluated in the same manner as in Example A1.

### (Example A3)

A solar cell is obtained in the same manner as in Example A1 except that Cu is not deposited but Mg is deposited after forming the p-type light-absorbing layer 3. The solar cell in Example A3 is evaluated in the same manner as in Example A1.

### (Example A4)

A solar cell is obtained in the same manner as in Example A1 except that Cu is not deposited but Li is deposited after forming the p-type light-absorbing layer 3. The solar cell in Example A4 is evaluated in the same manner as in Example A1.

### (Example A5)

A solar cell is obtained in the same manner as in Example A1 except that Cu is not deposited but Na is deposited after forming the p-type light-absorbing layer 3. The solar cell in Example A5 is evaluated in the same manner as in Example A1.

### (Example A6)

A solar cell is obtained in the same manner as in Example A1 except that Cu is not deposited but K is deposited after forming the p-type light-absorbing layer 3. The solar cell in Example A6 is evaluated in the same manner as in Example A1.

### (Example A7)

A solar cell is obtained in the same manner as in Example A1 except that Cu is not deposited but Rb is deposited after forming the p-type light-absorbing layer 3. The solar cell in Example A7 is evaluated in the same manner as in Example A1.

### (Example A8)

A solar cell is obtained in the same manner as in Example A1 except that Cu is not deposited but Cs is deposited after forming the p-type light-absorbing layer 3. The solar cell in Example A8 is evaluated in the same manner as in Example A1.

### (Example A9)

A solar cell is obtained in the same manner as in Example A1 except that Cu is not deposited but Be is deposited after forming the p-type light-absorbing layer 3. The solar cell in Example A9 is evaluated in the same manner as in Example A1.

### (Example A10)

A solar cell is obtained in the same manner as in Example A1 except that Cu is not deposited but Sr is deposited after forming the p-type light-absorbing layer 3. The solar cell in Example A10 is evaluated in the same manner as in Example A1.

### (Example A11)

A solar cell is obtained in the same manner as in Example A1 except that Cu is not deposited but Ba is deposited after forming the p-type light-absorbing layer 3. The solar cell in Example A11 is evaluated in the same manner as in Example A1.

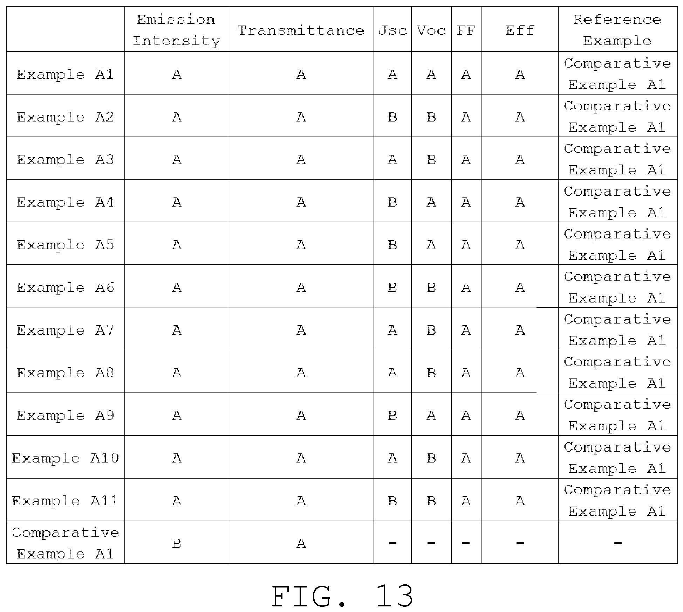

The evaluation results of the solar cells in Examples A are shown in a table of FIG. 13. From the results of Examples A1 to A11, it can be seen that repairing Cu vacancies improves Jsc, Voc, FF, and contributes to improving conversion efficiency.

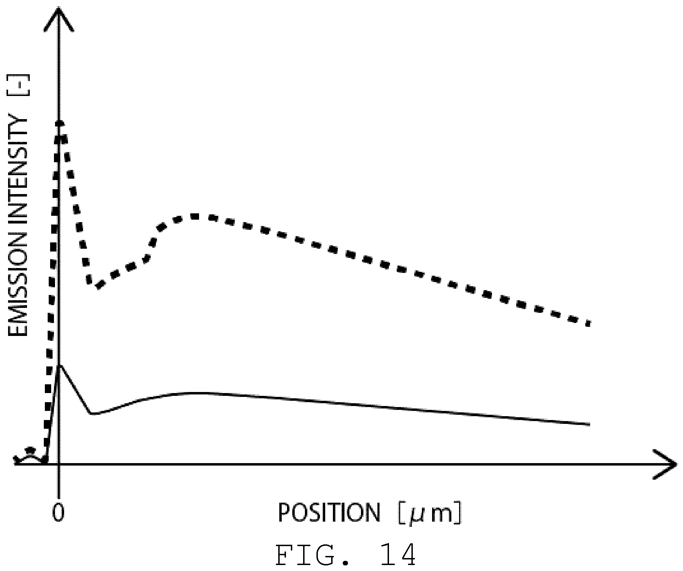

FIG. 14 shows the photoluminescence spectra of Example A1 and Comparative Example A1. The photoluminescence spectra in the examples are all smoothed measurement data. In FIG. 14, the solid line (Example A1) and the dashed line (Comparative Example A1) represent the emission intensity at a wavelength of 930 nm. The cross-sections at position A5 in FIG. 2 of the solar cells of Example A1 and Comparative Example A1 are shown with the interface between the p-type light-absorbing layer 3 and the n-type layer 4 as position 0 µm, and the distance in the direction of the first electrode 2 is taken as the horizontal axis. From the photoluminescence spectra in FIG. 14, it can be seen that Example A1 represented by a solid line shows a significant reduction in emission intensity at a wavelength of 930 nm.

Therefore, it is found that the maximum value of emission intensity in the wavelength range of 900 to 950 nm in the first region is 0 to 2 times the maximum value of emission intensity in the same wavelength range in the second region. Furthermore, for all the examples, the maximum value of emission intensity in the wavelength range of 900 to 950 nm in the first region is 0 to 2 times the maximum value of emission intensity in the same wavelength range in the second region.

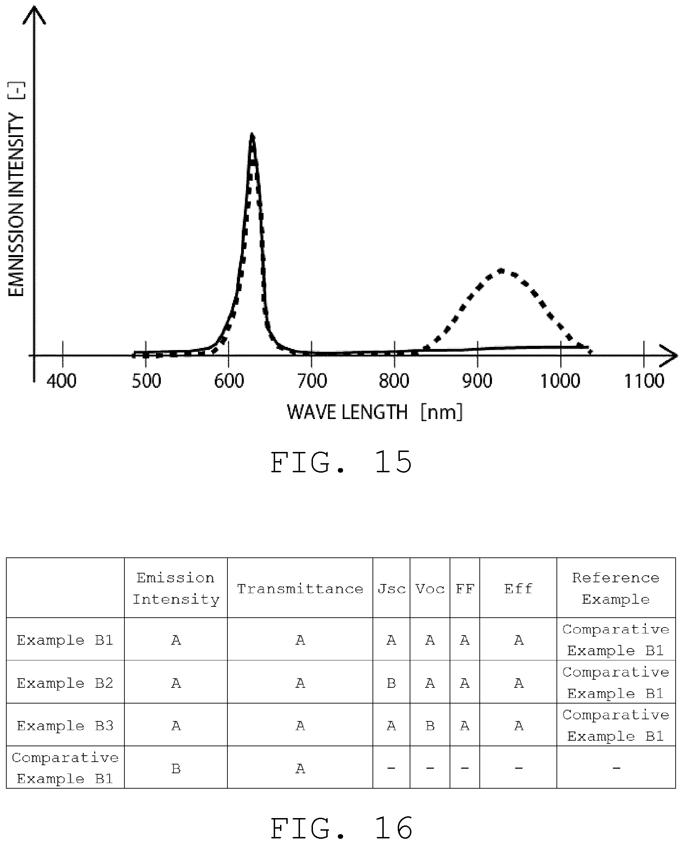

FIG. 15 shows the photoluminescence spectra of Example A1 (solid line) and Comparative Example A1 (dashed line) at position 0 µm. While Example A1 does not show noticeable emission with wavelengths of 900 nm or more, a peak centered around a wavelength of approximately 930 nm is observed in the same wavelength range for Comparative Example A1.

### (Example B)

### (Example B1)

ITO (In:Sn = 80:20, film thickness 150 nm) and ATO (Sn:Sb=98:2, film thickness 100 nm) are deposited on a glass substrate 1 as the first electrode 2 on the side in contact with the glass. On the ATO, a Cu₂O layer with a thickness of 6 µm is formed by sputtering in an oxygen and argon gas atmosphere as the p-type light-absorbing layer 3. After forming the p-type light-absorbing layer 3, a small amount of Cu is deposited. Then, a Ga₂O₃ film with a thickness of 10 nm is formed as the n-type layer 4. Then, AZO (ZnO:Al) with a thickness of 0.1 µm is deposited to obtain the solar cell 100. The solar cell in Example B1 is evaluated in the same manner as in Example A1.

### (Comparative Example B1)

A solar cell is obtained in the same manner as in Example B1 except that Cu is not deposited after forming the p-type light-absorbing layer 3. The solar cell in Comparative Example B1 is evaluated in the same manner as in Example A1.

### (Example B2)

A solar cell is obtained in the same manner as in Example A1 except that Cu is deposited at a higher temperature than in Example B1 when depositing a small amount of Cu after forming the p-type light-absorbing layer 3. The solar cell in Example B2 is evaluated in the same manner as in Example A1.

### (Example B3)

A solar cell is obtained in the same manner as in Example A1 except that Cu is deposited at a lower temperature than in Example B1 when depositing a small amount of Cu after forming the p-type light-absorbing layer 3. The solar cell in Example B3 is evaluated in the same manner as in Example A1.

The evaluation results of the solar cells in Example B are shown in a Table of FIG 16. In Examples B1 to B3, the diffusion distance of Cu that repairs Cu vacancies changes, but it can be seen that in all examples, repairing Cu vacancies improves Jsc, Voc, FF, and contributes to improving conversion efficiency. In addition, in all examples of Example B, the maximum value of emission intensity in the wavelength range of 900 nm or more and 950 nm or less in the first region is 0 times or more and 2 times or less than the maximum value of emission intensity in the same wavelength range in the second region.

### (Example C)

### (Example C1)

A Cu₂O layer as a p-type light-absorbing layer is epitaxially grown on an underlayer having a buffer layer between a NiW layer and an SRO (SrRuO₃) layer by the PLD method. A small amount of Zn is deposited on the Cu₂O layer. Then, a Ga₂O₃ film with a thickness of 10 nm is formed as the n-type layer 4. Then, AZO (ZnO:Al) with a thickness of 0.1 µm is deposited to obtain the solar cell 100. The solar cell in Example C1 is evaluated in the same manner as in Example A1.

### (Comparative Example C1)

A solar cell is obtained in the same manner as in Example C1 except that Zn is not deposited after forming the Cu₂O layer. The solar cell in Comparative Example C1 is evaluated in the same manner as in Example A1.

In Example C, it can also be seen that conversion efficiency improves when Cu vacancies is repaired.

### (Example D)

### (Example D1)

A Cu plate is subjected to oxidation treatment at approximately 1000 °C, and an Au electrode is formed as the first electrode 2 on one surface of the obtained cuprous oxide plate. A small amount of Zn is deposited on the opposite side of the obtained cuprous oxide plate. Then, a Ga₂O₃ film with a thickness of 10 nm is formed as the n-type layer 4. Then, AZO (ZnO:Al) with a thickness of 0.1 µm is deposited to obtain the solar cell 100. The solar cell in Example D1 is evaluated in the same manner as in Example A1.

### (Comparative Example D1)

A solar cell is obtained in the same manner as in Example D1 except that Zn is not deposited after forming the cuprous oxide plate. The solar cell in Comparative Example D1 is evaluated in the same manner as in Example A1.

In Example D, it can also be seen that conversion efficiency improves when Cu vacancy is repaired.

The solar cells of the embodiments including Examples are used as top cells, and Si solar cells are used as bottom cells in a multi-junction solar cell, contributing to an improvement in conversion efficiency. When the p-type light-absorbing layer 3 of the solar cell 100 includes a region of Cu defects, the region of Cu defects tends to absorb light in the wavelength band emitted by the Si solar cell. Therefore, the solar cells of the embodiments including Examples are suitable for use as multi-junction solar cells.

### (Example E)

### (Example E1)

ITO (In:Sn = 80:20, film thickness 150 nm) and ATO (Sn:Sb=98:2, film thickness 100 nm) are deposited on a glass substrate 1 as the first electrode 2 on the side in contact with the glass. On the ATO, a Cu₂O layer with a thickness of 6 µm is formed by sputtering in an oxygen and argon gas atmosphere as a layer mainly composed of cuprous oxide compound. After forming the p-type light-absorbing layer 3, a small amount of Cu is deposited. Then, a Ga₂O₃ film with a thickness of 10 nm is formed as the n-type layer 4. A ZnSnO (Zn:Sn=80:20) film with a thickness of 14 nm is formed on the Ga₂O₃ film as the n-type layer 4. Then, AZO (ZnO:Al) with a thickness of 0.1 µm is deposited to obtain solar cell 120.

A solar simulator that mimics an AM 1.5G light source is used, and the light intensity is adjusted to be 1 sun using a standard Si cell under the light source. The measurement is performed at atmospheric pressure with a room temperature of 25 °C. The voltage is swept, and the short-circuit current density Jsc (current divided by cell area) is measured. When the horizontal axis is voltage and the vertical axis is current density, the point where the horizontal axis intersects is the open-circuit voltage Voc. On the measurement curve, the point at which the product of voltage and short-circuit current density is maximized is defined as Vmpp and Jmpp (maximum power point). Then, FF = (Vmpp × Jmpp) / (Voc × Jsc), from which the fill factor can be calculated. Furthermore, Eff. = Voc × Jsc × FF, the conversion efficiency is obtained.

FF is evaluated as follows:
A when FF of the example is 1.05 times or more compared to FF of the reference example;
B: when FF of the example is 1.01 times or more and less than 1.05 times compared to FF of the reference example;
C when FF of the example is greater than 1.00 times and less than 1.01 times compared to FF of the reference example;
D when FF of the example is 0.90 times or more and 1.00 times or less compared to FF of the reference example; and
E when FF of the example is less than 0.90 times compared to FF of the reference example.

The FF evaluation is common from Example E to F.

Conversion efficiency is evaluated as follows:
A: when conversion efficiency of the example is 1.03 times or more compared to conversion efficiency of the reference example;
B when conversion efficiency of the example is greater than 1.00 times and less than 1.03 times compared to conversion efficiency of the reference example; and
C when conversion efficiency of the example is 1.00 times or less compared to conversion efficiency of the reference example.

The conversion efficiency evaluation is common from Example E to F.

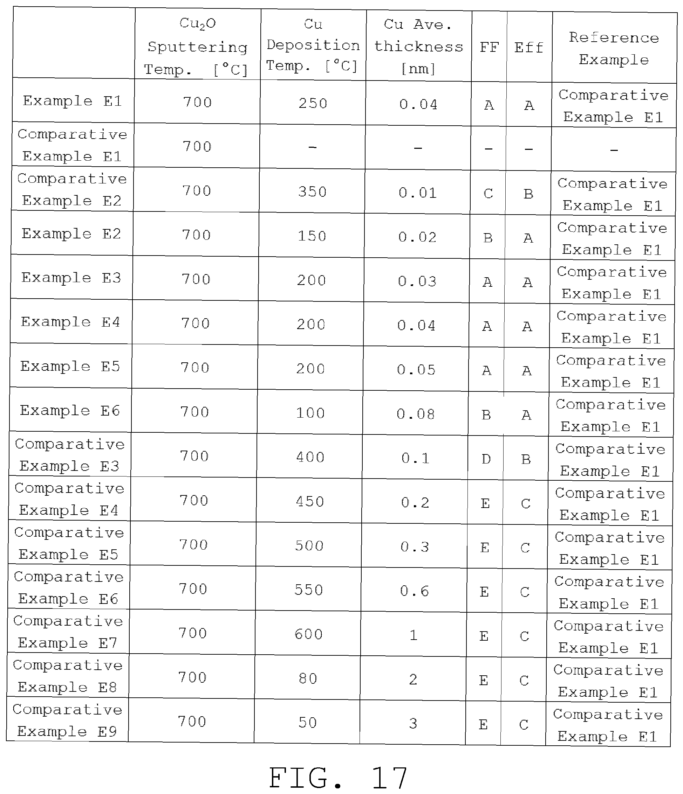

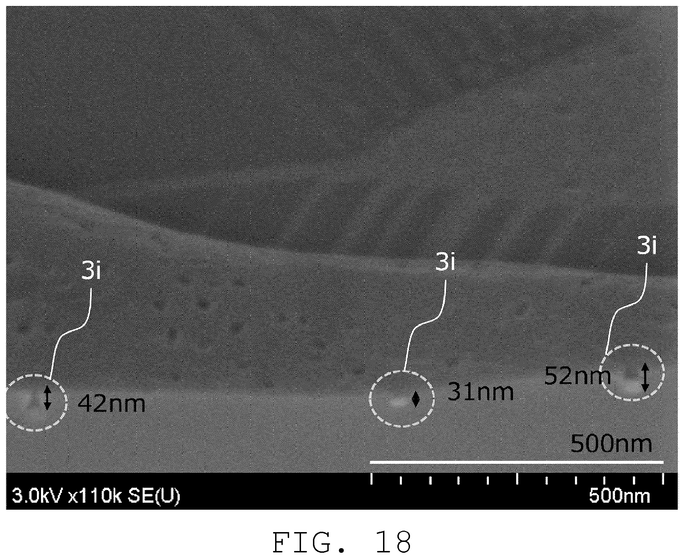

The temperature of the stage in sputtering the Cu₂O layer (Cu₂O sputtering temp.), the sputtering temperature of the Cu deposition stage (Cu deposition temp.), the average thickness of the deposited Cu (Cu Ave. thickness), the FF evaluation results, and the conversion efficiency evaluation results are shown in a table of FIG.17. FIG. 18 shows a SEM image of the p-type light-absorbing layer 3 before forming the n-type layer 4.

### (Comparative Example E1)

ITO (In:Sn = 80:20, film thickness 150 nm) and ATO (Sn:Sb=98:2, film thickness 100 nm) are deposited on a glass substrate 1 as the first electrode 2 on the side in contact with the glass. A Cu₂O layer with a thickness of 6 µm is formed by sputtering in an oxygen and argon gas atmosphere on the ATO. On top of the Cu₂O layer, a Ga₂O₃ film with a thickness of 10 nm is formed as the n-type layer 4, and a ZnSnO (Zn:Sn=80:20) film with a thickness of 14 nm is formed on the Ga₂O₃ film. Then, AZO (ZnO:Al) with a thickness of 0.1 µm is deposited to obtain a solar cell. The solar cell in Comparative Example E1 is evaluated in the same manner as in Example E1.

### (Examples E2-E6, Comparative Examples E2-E9)

Except for depositing Cu with varying thicknesses (amount of Cu ejected from the target), solar cells are obtained in the same manner as in Example E1. These examples are evaluated in the same way as Example E1. The temperature of the stage in sputtering the Cu₂O layer (Cu₂O sputtering temp.), the sputtering temperature of the Cu deposition stage (Cu deposition temp.), the average thickness of the deposited Cu (Cu Ave. thickness), the FF evaluation results, and the conversion efficiency evaluation results of examples (comparative examples) are shown in the table of FIG. 17.

As shown in the table of FIG. 17, FF and conversion efficiency changed by changing the thickness of Cu. In Comparative Example E2 with a deposited Cu thickness of 0.01 nm, there is little difference from Comparative Example E1 where Cu is not deposited. However, in Example E2 with a slightly thicker deposited Cu thickness of 0.02 nm, FF and conversion efficiency are significantly improved despite the small Cu thickness. When the deposited Cu thickness exceeded 1 nm, Cu diffused into the layer mainly composed of cuprous oxide compound, but some Cu that did not diffuse remained on the surface of the layer mainly composed of cuprous oxide compound and precipitated. In Comparative Examples E3-E9, which involved depositing amounts of Cu that resulted in precipitation, FF and conversion efficiency decreased as the amount of Cu deposition increased.

As shown in the SEM image in FIG. 18, multiple recesses 3i are formed on the surface of the p-type light-absorbing layer 3. The SEM image shows cross-sections of three recesses 3i. The depths of these recesses 3i are 42 nm, 31 nm, and 52 nm from left to right in the SEM image.

### (Example F)

### (Example F1)

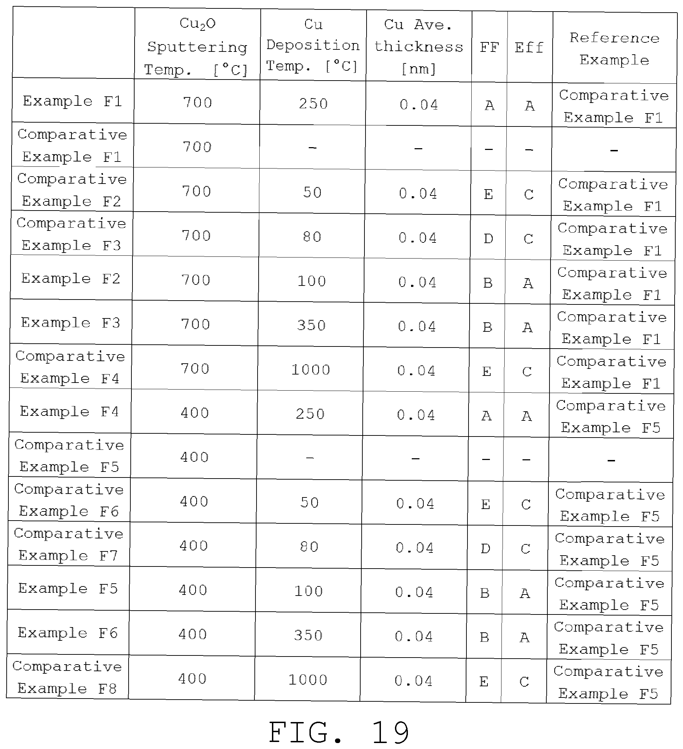

A solar cell 120 is obtained in the same manner as Example E1. These examples are evaluated in the same
manner as in Example E1. The temperature of the stage in sputtering the Cu₂O layer (Cu₂O sputtering temp.), the sputtering temperature of the Cu deposition stage (Cu deposition temp.), the average thickness of the deposited Cu (Cu Ave. thickness), the FF evaluation results, and the conversion efficiency evaluation results are shown in a table of FIG. 19.

### (Comparative Example F1)

A solar cell 120 is obtained in the same manner as Comparative Example E1. These examples are evaluated in the same manner as in Example E1. The temperature of the stage in sputtering the Cu₂O layer (Cu₂O sputtering temp.), the sputtering temperature of the Cu deposition stage (Cu deposition temp.), the average thickness of the deposited Cu (Cu Ave. thickness), the FF evaluation results, and the conversion efficiency evaluation results are shown in the table of FIG. 19.

### (Examples F2-F6, Comparative Examples F2-F8)

Except for changing the sputtering temperature of the Cu₂O layer stage and the deposition temperature of the Cu stage without changing the thickness of Cu deposited on the Cu₂O layer (Comparative Example F5 had no Cu deposition), solar cells are obtained in the same manner as in Example F1. These examples are evaluated in the same manner as in Example E1. The temperature of the stage in sputtering the Cu₂O layer (Cu₂O sputtering temp.), the sputtering temperature of the Cu deposition stage (Cu deposition temp.), the average thickness of the deposited Cu (Cu Ave. thickness), the FF evaluation results, and the conversion efficiency evaluation results are shown in the table of FIG. 19.

As shown in the table of FIG. 19, no improvement in FF and conversion efficiency is confirmed when the surface temperature of the layer mainly composed of cuprous oxide compound during Cu deposition is low or high. Precipitation of Cu on the surface of the layer mainly composed of cuprous oxide compound is observed at both high and low temperatures during Cu deposition.

### (Example G)

### (Example G1-G2, Comparative Examples G1-G2)

Simulations are performed for Example G under the following conditions. Solar cell 120 has a configuration that a p-type light-absorbing layer 3, first n-type layer 4A, second n-type layer 4B, and a second electrode 5 are stacked in that order. Through simulation, open-circuit voltage V, short-circuit current density mA/cm³, fill factor FF, and conversion efficiency Eff are determined. The substrate 1 is not considered in the simulation, but its presence or absence does not affect the simulation results. Therefore, the similar results as those described below would be obtained even when the substrate 1 are present. The first electrode 2 is also not considered in the simulation. The simulation software has limitations on the number of solar cell layers. When the p-type light-absorbing layer 3 and the first electrode 2 form an ohmic junction, the specific layer composition of the first electrode 2 can be ignored for evaluating its effect as a series resistance Rs. Therefore, assuming that the p-type light-absorbing layer 3 and the first electrode 2 form an ohmic junction (where the sheet resistance and interface resistance of the first electrode 2 are reflected in the series resistance Rs), simulations are performed on solar cell 120 excluding the first electrode 2. The simulation method used SCAPS (a Solar Cell Capacitance Simulator) and solved Poisson's equation and current continuity equation.

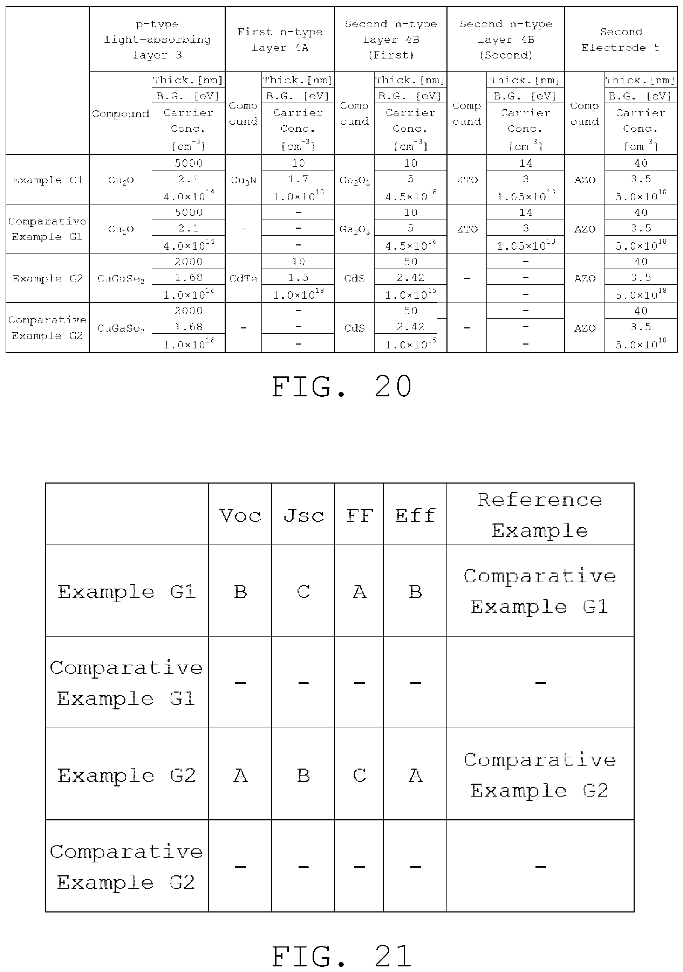

The simulation conditions (Compound, Thickness, Bandgap, Carrier Concentration) for the p-type light-absorbing layer 3, first n-type layer 4A, second n-type layer 4B, and second electrode 5 are shown in a table of FIG. 20. The simulation results are shown in a table of FIG. 21.

Jsc is evaluated as follows:
D: when Jsc of the example is less than Jsc mA/cm² of the reference example;
C: when Jsc of the example is 100% or more and less than 105% of Jsc mA/cm² of the reference example;
B: when Jsc of the example is 105% or more and less than 110% of Jsc mA/cm² of the reference example; and
A: when Jsc of the example is 110% or more of Jsc mA/cm² of the reference example.
The Jsc evaluation is common from Example G to Example I.

Voc is evaluated as follows:
D: when Voc of the example is less than Voc of the reference example;
C: when Voc of the example is 100% or more and less than 110% of Voc of the reference example;
B: when Voc of the example is 110% or more and less than 120% of Voc of the reference example; and
A: when Voc of the example is 120% or more of Voc of the reference example. The Voc evaluation is common from Example G to Example I.

FF is evaluated as follows:
D: when FF of the example is less than FF of the reference example;
C: when FF of the example is 100% or more and less than 105% of FF of the reference example;
B: when FF of the example is 105% or more and less than 110% of FF of the reference example; and
A: when FF of the example is 110% or more of FF of the reference example. The FF evaluation is common from Example G to Example I.

Eff is evaluated as follows:
D: when Eff of the example is less than Eff of the reference example;
C: when Eff of the example is 100% or more and less than 110% of Eff of the reference example;
B: when Eff of the example is 110% or more and less than 120% of Eff of the reference example; and
A: when Eff of the example is 120% or more of Eff of the reference example. The Eff evaluation is common from Example G to Example I.

As shown in the table of results, Voc, Jsc, FF, and Eff all improved by depositing a first n-type layer 4A with a band gap smaller than that of the p-type light-absorbing layer 3.

### (Example H)

### (Example H1-H5, Comparative Examples H1-H3)

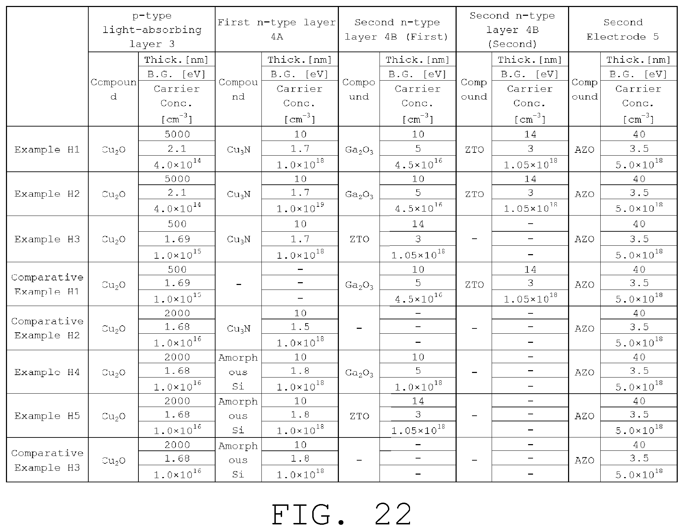

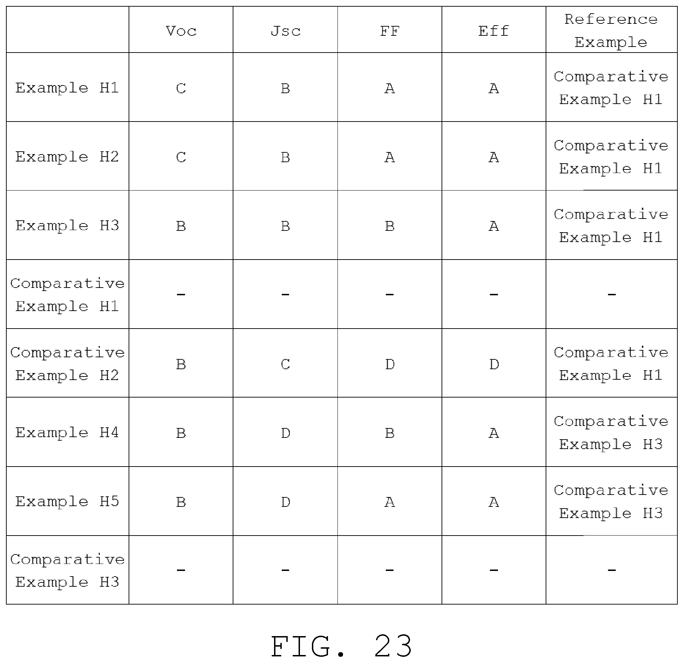

Simulations are performed in the same manner as in Example G using the cuprous oxide compound for the p-type light-absorbing layer 3 and changing the first n-type layer 4A and/or second n-type layer 4B. The simulation conditions are shown in a table of FIG. 22. The simulation results of Example H are also shown in a table of FIG. 23.

As shown in the table of results, Voc, Jsc, FF, and Eff all improved by depositing a first n-type layer with a band gap smaller than that of the cuprous oxide compound used for the p-type light-absorbing layer 3.

### (Example I)

### (Example I1-I2, Comparative Examples I1-I2)

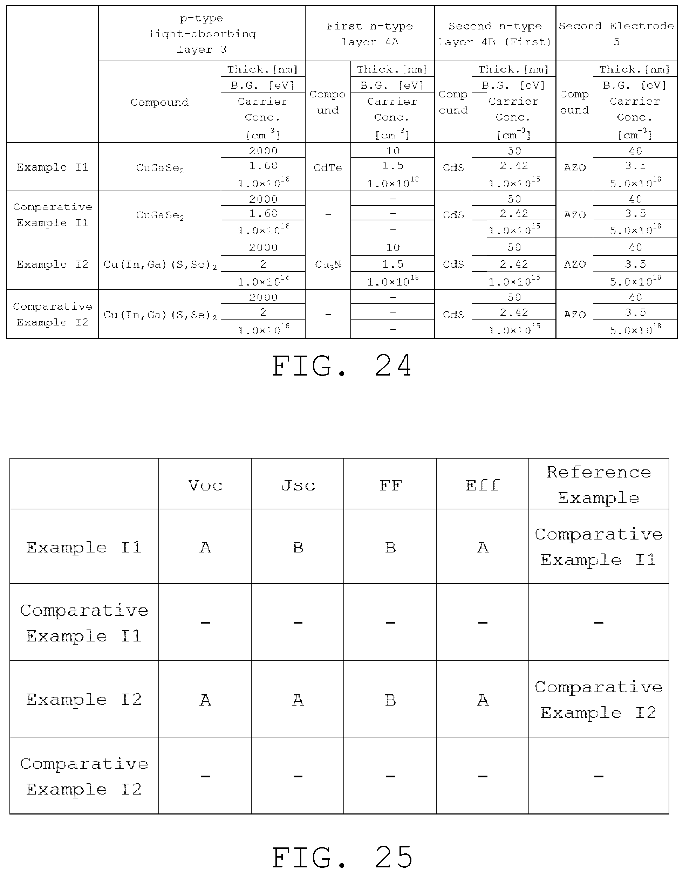

Simulations are performed in the same manner as in Example G using a compound with a chalcopyrite structure for the p-type light-absorbing layer 3 and changing the first n-type layer 4A and/or second n-type layer 4B. The simulation conditions are shown in a table of FIG.24. The simulation results of Example I are also shown in a table of FIG. 25.

As shown in the table of results, Voc, Jsc, FF, and Eff all improved by depositing a first n-type layer with a band gap smaller than that of the compound with a chalcopyrite structure used for the p-type light-absorbing layer 3.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

Some elements in the specification are represented by element symbols only.

p-type light-absorbing layerp-type light-absorbing layerp-type light-absorbing layerp-type light-absorbing layerp-type light-absorbing layerp-type light-absorbing layerp-type light-absorbing layerp-type light-absorbing layerp-type light-absorbing layer

## Claims

1. A solar cell (100) comprising:
a first electrode (2);
a p-type light-absorbing layer (3) on the first electrode (2);
an n-type layer (4) on the p-type light-absorbing layer (3); and
a second electrode (5) on the n-type layer (4), wherein
a region from the n-type layer (4) side surface of the p-type light-absorbing layer (3) to the first electrode (2) side with a depth of 100 nm is defined as a first region (3a),
a region from the center of the thickness direction of the p-type light-absorbing layer (3) to the first electrode (2) side with a depth of 100 nm is defined as a second region (3b), and
when the photoluminescence spectrum of the p-type light-absorbing layer (3) is measured at a temperature of 100 K or less, the maximum value of the emission intensity in the wavelength range of 900 nm or more and 950 nm or less for the first region (3a) is 0 times or more and 2 times or less than the maximum value of the emission intensity in the same wavelength range for the second region (3b).

2. The solar cell (100) according to claim 1, wherein
the p-type light-absorbing layer (3) comprises a cuprous oxide compound as its main component,
the cuprous oxide compound as the main component of the p-type light-absorbing layer (3) includes one or more first elements selected from the group consisting of Zn, Mg, Li, Na, K, Rb, Cs, Be, Ca, Sr, and Ba on the n-type layer (4) side;
a region extending from a surface of the p-type light-absorbing layer (3) on the side opposite the first electrode (2) to the first electrode (2) with a depth of 1 µm is defined as a third region (3c), and
concentration of the first element included in the third region (3c) is 90 atom% or more and 100 atom% or less of concentration of the first element included in the p-type light-absorbing layer (3).

3. The solar cell (100) according to claim 1 or 2, wherein
The p-type light-absorbing layer (3) comprises a cuprous oxide compound as its main component, and
the surface resistivity Ω/cm² of the first region (3a) is 0.3 times or more and 10000 times or less than the surface resistivity Ω/cm² of the second region (3b).

4. The solar cell (100) according to claim 2 or 3, wherein
The p-type light-absorbing layer (3) comprises a cuprous oxide compound as its main component,
a region extending from a surface of the p-type light-absorbing layer (3) on the side opposite the first electrode (2) to the first electrode (2) with a depth of 50 nm is defined as a fourth region (3d), and
a concentration of the first element included in the fourth region (3d) is 30 atom% or more and 80 atom% or less of a concentration of the first element included in the p-type light-absorbing layer (3).

5. The solar cell (100) according to any one of claims 1 to 4, wherein
The p-type light-absorbing layer (3) comprises a cuprous oxide compound as its main component,
a carrier concentration in the first region (3a) is 1 × 10¹¹ cm⁻³ or more and 1 × 10¹⁵ cm⁻³ or less, and
a carrier concentration in the second region is 1 × 10¹² cm⁻³ or more and 1 × 10¹⁵ cm⁻³ or less.

6. The solar cell (100) according to any one of claims 1 to 5, wherein
the p-type light-absorbing layer (3) comprises a cuprous oxide compound as its main component,
a carrier concentration in the first region (3a) is 1 × 10¹¹ cm⁻³ or more and 3 × 10¹⁴ cm⁻³ or less,
a carrier concentration in the second region (3b) is 1 × 10¹³ cm⁻³ or more and 7.5 × 10¹⁴ cm⁻³ or less, and
the carrier concentration in the first region (3a) is 0.0001 times or more and 3 times or less than the carrier concentration in the second region (3b).

7. The solar cell (100) according to any one of claims 1 to 6, wherein
a wavelength range from 900 nm to 950 nm is defined as a first wavelength range,
a wavelength range from 600 nm to 650 nm is defined as a second wavelength range, and
value of ([maximum value of emission intensity in the first wavelength range in the first region (3a)] × [maximum value of emission intensity in the second wavelength range in the second region (3b)]) / ([maximum value of emission intensity in the second wavelength range in the first region (3a)] × [maximum value of emission intensity in the first wavelength range in the second region (3b)]) is 0 or more and 20 or less.

8. The solar cell (100) according to any one of claims 1 to 7, wherein
the p-type light-absorbing layer (3) is polycrystalline.

9. The solar cell (100) according to any one of claims 2 to 4, wherein
the p-type light-absorbing layer (3) is polycrystalline of the cuprous oxide compound, and
the first element is present at grain boundaries included in the first region (3a).

10. The solar cell (100) according to any one of claims 1 to 9, wherein
the p-type light-absorbing layer (3) comprises a cuprous oxide compound as its main component, and
the p-type light-absorbing layer (3) includes crystals of the cuprous oxide compound with a grain size 5 times or more the thickness of the p-type light-absorbing layer (3).

11. The solar cell (100) according to any one of claims 1 to 10, wherein
the first electrode (2) is a transparent electrode, and
the second electrode (5) is a transparent electrode.

12. The solar cell (100) according to any one of claims 1 to 11, wherein
a thickness of the p-type light-absorbing layer (3) is 500 nm or more and 10um or less.

13. A multi-junction solar cell (200) comprising:
the solar cell (100) according to any one of claims 1 to 12.

14. A solar cell module (300) comprising:
the solar cell (100) according to any one of claims 1 to 12.

15. A photovoltaic power generation system (400) comprising:
the solar cell module (300) according to claim 14.
